# EUROPEAN PATENT APPLICATION

(11) **EP 4 745 933 A1**
(43) Date of publication of application: **20.05.2026**
(21) Application number: 24213223.1
(22) Date of filing: 15.11.2024
(51) Int. Cl.: G08B 13/00, G01R 31/12, G08B 13/24

(54) **IMPROVED SECURITY MONITORING SYSTEM**

(71) Applicant: Verisure Sàrl, 1290 Versoix (CH)
(72) Inventor: PIEDBOIS, Julien, 1290 Versoix (CH); HACKETT, Nicolas, 1290 Versoix (CH)
(74) Representative: Hansson Thyresson AB

(57) **Abstract**

There is provided a security monitoring system for monitoring of a premises, the security monitoring system comprising: a control unit, and an electrical discharge detector configured to detect electrical discharges in electrical wiring of the premises. There is also provided a method of operating a security monitoring system of a premises, the method comprising: detecting, by an electrical discharge detector of the security monitoring system, an electrical discharge in electrical wiring of the premises; and in response to the detection, transmitting an action signal to one or more devices.

## Description

### TECHNICAL FIELD

The present invention relates to a security monitoring system comprising an electrical discharge detector for detecting electrical discharges in electrical wiring, and to methods of operating the same.

### BACKGROUND

Security installations that are or include security monitoring systems for monitoring premises (e.g. a building such as a home), often referred to as alarm systems, typically provide means for detecting undesirable security or safety events and reacting to detected events. Such detection means may include Wi-Fi sensing systems, presence sensors, motion sensors and/or perimeter sensors for monitoring an area of the premises and detecting an unauthorized intruder entering or moving within or around the premises. Additionally, or alternatively, the means may include fire detection means such as a smoke detector for detecting smoke likely originating from a fire inside the premises.

Such systems may be self-contained, with alarm indicators such as sirens and flashing lights that may be activated when an undesirable security or safety event is detected. Alternatively, or additionally, such systems may be linked to a remote monitoring centre where, typically, human operators manage the responses required by different alarm and notification types.

Hence, the security monitoring systems can alert a user (e.g. a homeowner) or an operator (e.g. at a remote monitoring centre or at the emergency services) that an undesirable security or safety event has occurred. Accordingly, such security monitoring systems contribute to the safety and wellbeing of occupants of the protected premises as well as safeguarding articles within the protected premises.

However, a smoke detector may only detect smoke after a fire has generated a sufficient amount of smoke. At this point in time, the occupants of the premises and/or the premises themselves (e.g. if no occupants are present in the premises) may face significant danger even if the security monitoring system alerts the occupant (e.g. by a siren), an operator and/or the emergency services.

From the above, it is understood that there is room for improvements in security monitoring systems and the invention aims to solve or at least mitigate the above and other problems. Accordingly, embodiments of the present invention seek to provide enhanced security monitoring systems, methods and other implementations that improve the scope of such systems to address aspects of safety and security as well as providing new functionality and methods.

### SUMMARY

The invention is defined by the appended independent claims. Additional features and advantages of the concepts disclosed herein are set forth in the description which follows, and in part will be obvious from the description, or may be learned by practice of the described technologies. The features and advantages of the concepts may be realized and obtained by means of the instruments and combinations particularly pointed out in the appended claims. These and other features of the described technologies will become more fully apparent from the following description and appended claims, or may be learned by the practice of the disclosed concepts as set forth herein.

In a first aspect, there is provided a security monitoring system for monitoring of a premises, the security monitoring system comprising: a control unit, and an electrical discharge detector configured to detect electrical discharges in electrical wiring of the premises. The security monitoring system according to the first aspect allows electrical discharges that could potentially precede electrical fires to be detected. Hence the fire safety of the premises is improved.

The electrical discharge detector may be configured to be connected to an outlet of electrical wiring in the premises. Accordingly, the electrical discharge detector may comprise: a plug for connection to an outlet of the electrical wiring, and a detection unit for detecting an electrical discharge. The electrical discharge detector may be configured to detect electrical discharges using any suitable method. For example, the electrical discharge detector may be configured to: measure an electrical signal waveform of the electrical wiring, identify one or more transient signals within the waveform; and detect the electrical discharge in dependence on transient characteristics of the one or more transient signals.

Optionally, the security monitoring system is configured to, in response to a detected electrical discharge, transmit an action signal to one or more devices instructing the one or more devices to perform one or more actions. For example, the electrical discharge detector may be configured to transmit a detection signal in response to the detected electrical discharge. The detection signal may, for example, be transmitted to the control unit, which may in turn be configured to transmit, in response to the detection signal, the action signal to one or more devices instructing the one or more devices to perform one or more actions. As another example, the electrical discharge detector may be configured to transmit the action signal directly to the one or more devices.

The actions may include actions relating to increasing an alertness and/or a potential fire detection or prevention performance of the security monitoring system. The actions may additionally or alternatively include actions relating to reducing a load on the electrical wiring of the premises.

Optionally, the security monitoring system further comprises a remote monitoring centre. The remote monitoring centre may be configured to receive a detection signal from the electrical discharge detector and to, in response thereto, transmit the action signal. Optionally, the control unit may be configured to transmit an alert signal to the remote monitoring centre in response to a detected electrical discharge such that the remote monitoring centre can notify emergency services and/or an occupant or owner of the premises.

Optionally, the security monitoring system further comprises one or more sensors for monitoring the premises. The one or more sensors may comprise a presence sensor, a radiation-based sensor, a thermal sensor, an infrared sensor, a passive infrared sensor, a line-of-sight sensor, a motion sensor, a photosensor, a smoke detection sensor, a temperature sensor, a shock sensor, a sound sensor, an image capturing sensor, or any combination of one or more thereof.

At least one of the sensors may be configurable between a first state and a second state. In such a case, the system may be configured to alter the configurable sensor from the first state to the second state in response to detection of an electrical discharge by the electrical discharge detector. The second state may comprise any one or more of: an active state, a high-sensitivity state; and a fire detection mode.

In particular, the configurable sensor(s) may further be configured to, in the second state, monitor an area of the premises. Alternatively, or additionally, the configurable sensor may be configured to transmit monitoring data to one or more devices, such as a user device, a remote monitoring centre device, or the like.

The configurable sensor(s) in the second state may be configured to monitor a parameter indicative of a potential fire in the premises. The security monitoring system may further be configured to transmit an alert signal in response to a value of the parameter being indicative that a fire has potentially started in the premises.

Optionally, at least one of the configurable sensors is or comprises a temperature sensor, wherein the temperature sensor in the second state is configured to monitor a temperature in the premises, optionally, wherein the security monitoring system is configured to transmit an alert signal in response to the monitored temperature exceeding a temperature threshold, optionally, wherein the temperature threshold in the second state is lower than a temperature threshold in the first state.

Optionally, at least one of the configurable sensors is or comprises a thermal radiation-based sensor, such as an infrared sensor, wherein the thermal radiation-based sensor in the second state is configured to monitor an amount of incident thermal radiation, optionally, wherein the security monitoring system is configured to transmit an alert signal in response to the amount of incident thermal radiation exceeding a radiation threshold, optionally, wherein the incident thermal radiation threshold in the second state is lower than an incident thermal radiation threshold in the first state.

Optionally, at least one of the configurable sensors is or comprises a smoke detection sensor configured to detect smoke, the smoke detection sensor having a smoke detection threshold, optionally, wherein the smoke detection sensor in the second state has a lower smoke detection threshold than the smoke detection threshold in the first state, optionally, wherein the security monitoring system is configured to transmit an alert signal in response to the smoke detected exceeding the smoke detection threshold.

Optionally, at least one of the configurable sensors is or comprises an image capturing sensor, wherein the security monitoring system is configured to determine an amount of target colours in a field of view of the image capturing sensor, optionally, wherein the security monitoring system is configured to transmit an alert signal in response to the determined amount exceeding a target colour threshold.

Optionally, the security monitoring system is further configured to determine an area of the premises in which the electrical discharge has occurred, and identify at least one sensor of the security monitoring system configured to monitor at least part of the determined area, wherein the sensor that is altered from the first state to the second state comprises the identified sensor.

The security monitoring system may further comprise at least one presence inferring means configured to infer or detect if anyone is present at the premises. The presence inferring means may comprise any one or more of: a presence sensor, a radiation-based sensor, an infrared sensor, a passive infrared sensor, a motion sensor, a photosensor, a temperature sensor, a shock sensor, a sound sensor, and/or an image capturing sensor. Alternatively, or additionally, the presence inferring means may comprise a radio-based presence sensing arrangement configured to detect perturbations in radio signals (e.g. Wi-Fi signals) transmitted and/or received by the radio-based presence sensing arrangement. Yet alternatively, or additionally, the presence inferring means may comprise a processor configured to process data relating to one or more security states, a time of day, one or more habits or patterns of one or more occupants of the premises, one or more inputs received from a device, and/or data received from a radio-based presence sensing arrangement, in order to determine if anyone is present in the premises.

Optionally, the security monitoring system may be configured to store and/or retrieve data relating to one or more security states of the security monitoring system, one or more habits or patterns of one or more occupants, and/or data relating to a current time and/or date.

Optionally, the security monitoring system is further configured to determine a severity of the detected electrical discharge; and in response to the determined severity exceeding a severity threshold, trigger an alarm, optionally, wherein the triggering of the alarm comprises activating a siren within the premises.

Optionally, the security monitoring system comprises a plurality of electrical discharge detectors. The plurality of electrical discharge detectors allows a determination to be made of where in an electrical wiring the electrical discharge is likely to have occurred.

Optionally, the security monitoring system further comprises a radio-based sensing arrangement. The radio-based sensing arrangement may be configured to detecting human presence within premises in dependence on perturbations in radio signals. The radio-based sensing arrangement may comprise: a plurality of nodes for transmitting and/or receiving the radio signals, wherein at least one of the nodes is an illuminator node configured to transmit one or more of the radio signals, and at least one of the nodes is a receiver node configured to receive the radio signals.

At least one of the nodes of the radio-based sensing arrangement may be formed by the electrical discharge detector. The electrical discharge detector may accordingly comprise a radio transmitter, optionally a radio transceiver.

Optionally, the radio signals are Wi-Fi signals, and the radio-based sensing arrangement is a Wi-Fi sensing arrangement. The electrical discharge detector may, in such a configuration, comprise a Wi-Fi transmitter, optionally a Wi-Fi transceiver.

Optionally, the electrical discharge detector forms the receiver node. The electrical discharge detector may then comprise a processing unit configured to process the received radio signals to detect one or more perturbations.

Optionally, the electrical discharge detector forms an illuminator node configured to transmit at least one of the radio signals to the receiver node.

Optionally, at least one of the sensors of the security monitoring system forms a node, optionally an illuminator node, of the radio-based sensing arrangement.

Optionally, the control unit of the security monitoring system forms a node, optionally a receiver node, of the radio-based sensing arrangement.

The security monitoring system may be connected to a smart-home system comprising one or more smart devices. The smart-home system may be installed in a premises. The security monitoring system may be configured to, in response to a detected electrical discharge, transmit an action signal to at least one of the smart devices instructing the at least one smart device, and in particular at least one smart device connected to the electrical wiring, to be turned off. Hence, a load on the electrical wiring may be reduced upon detection of an electrical discharge, which in turn may reduce the risk of a potential fire arising as a consequence of the detected electrical discharge or any subsequent electrical discharges.

Optionally, the control unit may be configured to receive a detection signal from the electrical discharge detector in response to a detected electrical discharge, and to transmit the action signal instructing one or more of the smart devices to be turned off.

The smart-home system may optionally comprise a smart-home controller configured to act as a gateway between the security monitoring system and the one or more smart devices.

Optionally, the one or more smart devices includes one or more smart plugs, one or more smart wall switches, one or more smart-home appliances, one or more smart luminary devices, one or more smart home entertainment devices, one or more smart security monitoring sensors, or any combination of one or more thereof.

Optionally, the security monitoring system is further configured to: determine a section of electrical wiring affected by a detected electrical discharge, identify one or more smart devices connected to the affected section, and transmit the action signal to the one or more identified smart devices instructing the at least one smart device to be turned off. The load on an affected section of electrical wiring may accordingly be reduced, while smart devices connected to other sections of electrical wiring may still be kept turned on and functional.

The security monitoring system according to the first aspect may be configured to perform or execute the method of the second aspect.

In a second aspect, there is provided a method of operating a security monitoring system of a premises. The method comprises: detecting, by an electrical discharge detector of the security monitoring system, an electrical discharge in electrical wiring of the premises; and, in response to the detection, transmitting an action signal to one or more devices instructing the one or more devices to perform an action. The method allows electrical discharges that could potentially precede electrical fires to be detected and, in response thereto, an action is performed, thereby potentially improving the fire safety.

The actions may include actions relating to increasing an alertness and/or a potential fire detection or prevention performance of the security monitoring system. The actions may additionally or alternatively include actions relating to reducing a load on the electrical wiring of the premises.

Optionally, the electrical discharge detector comprises a plug inserted into an outlet of the electrical wiring. The detection step may comprise the steps of: measuring an electrical signal waveform of the electrical wiring, identifying one or more transient signals within the waveform; and detecting the electrical discharge in dependence on transient characteristics of the one or more transient signals. The detection may alternatively be performed by any other suitable method.

The method may further comprise: determining a severity of the detected electrical discharge; and in response to the determined severity exceeding a severity threshold, triggering an alarm, optionally wherein the triggering of the alarm comprises activating a siren within the premises.

The method may further comprise a step of performing the action in response to the action signal. In particular, the method may include any combination of one or more of the first to third examples outlined below.

In a first example, the method may include altering a state of at least one sensor of the security monitoring system from a first state to a second state. Accordingly, an alertness of the security monitoring system is increased, and a potential fire detection performance of the security monitoring system is improved.

The at least one sensor may be any sensor of a security monitoring system, such as a security monitoring system according to the first aspect, and may for example comprise a presence sensor, a thermal sensor, a radiation-based sensor, an infrared sensor, a motion sensor, a photosensor, a smoke detection sensor, a temperature sensor, an image capturing sensor, or any combination thereof.

In embodiments, the method may further comprise monitoring, using the sensor in the second state, an area of the premises. For example, a user and/or operator may monitor an output from the sensor in the second state. Alternatively and/or additionally, the monitoring may be performed, for example automatically, by the security monitoring system and/or the sensor.

The sensor in the second state may be configured to monitor a parameter indicative of a potential fire in the premises. For example, the indicative parameter may include a smoke amount, a temperature, an incident light amount (e.g. of one or more specific wavelengths such as wavelengths corresponding to one or more target colours), an incident heat amount, an incident radiation (e.g. thermal radiation, infrared radiation) amount, or any combination thereof.

The method may further comprise transmitting an alert signal in response to a value of the parameter being indicative that a fire has potentially started in the premises. The parameter may be considered indicative of a potential fire if the parameter value changes in a way that is consistent with what is expected if a potential fire has started in the premises, e.g. based on a comparison of the parameter value with one or more reference or threshold values. For example, the parameter may be considered indicative of a potential fire if the parameter value exceeds a threshold value, such as if a detected smoke amount exceeds a threshold value. As another example, the parameter may be considered indicative of a potential fire if the parameter value falls below a threshold value, such as if a visibility parameter falls below a threshold (e.g. due to the line of sight being obscured by smoke). As yet another example, the parameter may be considered indicative if the parameter value increases and/or decreases by a predetermined amount (e.g. relative to an initial and/or reference value), for example within a predetermined time period (e.g. a short time period indicating a sudden change in the parameter value), such as if there is a sudden increase in temperature and/or thermal (e.g. infrared) radiation.

The altering of the at least one sensor from the first state to the second state may comprise any one or more of: activating the sensor; increasing the sensitivity of the sensor; and putting the sensor into a fire detection mode.

Optionally, at least one of the sensors comprises a temperature sensor, wherein the temperature sensor in the second state is configured to monitor a temperature in the premises, optionally, wherein the method comprises transmitting an alert signal in response to the monitored temperature exceeding a temperature threshold, optionally, wherein the temperature threshold in the second state is lower than a temperature threshold in the first state.

Optionally, at least one of the sensors comprises a thermal radiation-based sensor, such as an infrared sensor, wherein the thermal radiation-based sensor in the second state is configured to monitor an amount of incident thermal radiation, optionally, wherein the method comprises transmitting an alert signal in response to the amount of incident thermal radiation exceeding a radiation threshold, optionally, wherein the incident thermal radiation threshold in the second state is lower than an incident thermal radiation threshold in the first state.

Optionally, at least one of the sensors comprises a smoke detection sensor configured to detect smoke, the smoke detection sensor having a smoke detection threshold, optionally, wherein the smoke detection sensor in the second state has a lower smoke detection threshold than the smoke detection threshold in the first state, optionally, wherein the method comprises transmitting an alert signal in response to the smoke detected exceeding the smoke detection threshold.

Optionally, at least one of the sensors comprises an image capturing sensor, wherein the method further comprises determining an amount of target colours in a field of view of the image capturing sensor, optionally, wherein the method further comprises transmitting an alert signal in response to the determined amount exceeding a target colour threshold.

Additionally, or alternatively, the method may further comprise: determining an area of the premises in which the electrical discharge has occurred, and identifying at least one sensor of the security monitoring system configured to monitor at least part of the determined area, wherein the sensor that is altered from the first state to the second state comprises the identified sensor.

In a second example, the method may include: determining if anyone is present in the premises; selecting one of a first action and a second action in dependence on the determination, wherein the first action is selected if it is determined that someone is present, and the second action is selected if it is determined that no one is present; and performing one of the first and second actions in dependence on the selection. Hence, the security monitoring system can tailor its response to a detected electrical discharge in dependence on whether anyone is present in the premises or not. Accordingly, the security monitoring system can take an appropriate action is someone is in potential danger, while potentially taking a less urgent action if no one is in immediate danger.

The presence determination may be performed in dependence on the detection of the electrical discharge. Alternatively, or additionally, presence determination may already have been performed prior to (e.g. shortly before) the electrical discharge is detected.

The first action may include starting an alarm indicator in the premises and/or notifying emergency services. Hence, people present in the premises and/or emergency services are appropriately alerted that a potential fire may start in the premises as a result of the faulty electrical wiring causing the electrical discharge. The second action, on the other hand, may include: altering a sensor state of one or more sensors of the security monitoring system, and/or monitoring the premises by one or more sensors of the security monitoring system, and/or sending a notification to a device, and/or contacting a person associated with the premises, and/or notifying a remote monitoring centre. Hence, the security monitoring system can take action without unnecessarily contacting the emergency services.

The device to which a notification may be sent may be a control unit of the security monitoring system, a device of a remote monitoring centre, a user device (e.g. of an individual associated with the premises such as an occupant or owner), and/or a server associated with a web portal or the like.

Optionally, the step of determining if anyone is present in the premises comprises inferring the presence from one or more security states of the security monitoring system. The security states may comprise any one or more of: an armed or disarmed state of the security monitoring system, a locked or unlocked state of one or more electronic door locks of the security monitoring system, and a state of one or more perimeter sensors indicating that a door or window is open or closed. Optionally, the method further comprises determining that someone is present if at least one of the security states infers presence. The security state(s) are typically known by the security monitoring system, and/or be quickly determined by the security monitoring system, thus ensuring a fast response to the detected electrical discharge.

Alternatively, or additionally, the step of determining if anyone is present in the premises comprises detecting the presence by one or more sensors of the security monitoring system. The one or more sensors may comprise any one or more of: a presence sensor, a radiation-based sensor, an infrared sensor, a passive infrared sensor, a motion sensor, a photosensor, a temperature sensor, a shock sensor, a sound sensor, and/or an image capturing sensor. Hence, the security monitoring system can advantageously utilise its already present sensors for a second purpose (in addition to their primary purpose of detecting an intruder). Optionally, the step of detecting the presence may comprise activating at least one of the one or more sensors and/or monitoring the premises by at least one of the one or more sensors.

Additionally, or alternatively, the method may comprise determining a time of day, and inferring presence in dependence on the time of day and typical habits of one or more occupants of the premises. The determination of the time of day may include receiving the time of day from a device (e.g. a device of the security monitoring system), such as a control unit, one or more sensors or any other device programmed with the time and/or date. Furthermore, the security monitoring system may know one or more habits or patterns of an occupant (e.g. that the occupant always leaves the premises at certain times). This may be known from typical patterns of when the user arms/disarms the security monitoring system, from typical patterns of when a sensor (e.g. a doorbell camera and/or a perimeter sensor) notices that the occupant leaves/enters the premises, from typical patterns of when a radio-based presence sensing arrangement notices when an occupant is present in one or more areas of the premises, or the like.

Optionally, at least one of the one or more sensors comprises an image capturing sensor, wherein the method optionally comprises: acquiring an image from the image capturing sensor, determining a lighting amount in the premises, determining a time of day, and inferring presence in dependence on the time of day. The security monitoring system may accordingly be configured to infer presence if the lighting amount is inconsistent with a typical (or reference) lighting amount associated with the determined time of day. For example, if the time of day is consistent with nighttime and the lighting amount is greater than a threshold amount, it may be inferred that e.g. a lamp is turned on meaning that someone is likely present in the building.

Alternatively, or additionally, the step of determining if anyone is present in the premises comprises detecting the presence by a radio-based presence sensing arrangement which may or may not be part of the security monitoring system. This is particularly advantageous if one or more devices (e.g a control unit, an electrical discharge detector, and/or one or more sensors) of the security monitoring system function as nodes in the radio-based presence sensing arrangement. The radio-based presence sensing arrangement may be configured to detect perturbations in radio signals (e.g. Wi-Fi signals) transmitted and/or received by the radio-based presence sensing arrangement.

Alternatively, or additionally, the step of determining if anyone is present in the premises comprises determining the presence in dependence on an input from a user. Optionally, the method further comprises: transmitting a request to one or more devices, receiving an input from at least one of the devices in response to the request, and determining presence in dependence on the received input. The at least one device may include a control unit of the security monitoring system, a device of a remote monitoring centre, a user device (e.g. of an individual associated with the premises such as a tenant or owner), and/or a server associated with a web portal or the like. Optionally, the method further comprises: if no input has been received within a predetermined time period, transmitting a second request to one or more devices.

In a third example, the action signal is transmitted to one or more smart devices instructing the one or more smart devices to be turned off. The smart devices may be part of a smart-home system connected to or comprised by the security monitoring system.

Hence, a load on the electrical wiring may be reduced upon detection of an electrical discharge, which in turn may reduce the risk of a potential fire arising as a consequence of the detected electrical discharge or any subsequent electrical discharges.

The one or more smart devices may include one or more smart plugs, one or more smart wall switches, one or more smart-home appliances, one or more smart luminary devices, one or more smart home entertainment devices, one or more smart security monitoring sensors, or any combination of one or more thereof.

Optionally, the method further comprises: determining a section of electrical wiring affected by the detected electrical discharge, and identifying one or more smart devices connected to the affected section, wherein the command is transmitted to the one or more identified smart devices.

Optionally, the method further comprises: transmitting a request to a device, receiving a response from the device indicating at least one smart device to be turned off, wherein the command is transmitted to the at least one indicated smart device.

In a third aspect, there is provided a radio-based sensing arrangement for detecting human presence within premises, the radio-based sensing arrangement being configured to detect human presence in dependence on perturbations in radio signals, the radio-based sensing arrangement comprising: a plurality of nodes for transmitting and/or receiving the radio signals, wherein at least one of the nodes is an illuminator node configured to transmit one or more of the radio signals, and at least one of the nodes is a receiver node configured to receive the radio signals; and an electrical discharge detector for detecting an electrical discharge in electrical wiring of the premises, wherein the electrical discharge detector forms one of the nodes.

Optionally, the electrical discharge detector comprises a radio transmitter, optionally a radio transceiver.

Optionally, the radio signals are Wi-Fi signals, and the radio-based sensing arrangement is a Wi-Fi sensing arrangement.

Optionally, the electrical discharge detector comprises a Wi-Fi transmitter, optionally a Wi-Fi transceiver.

Optionally, the electrical discharge detector forms the receiver node.

Optionally, the electrical discharge detector comprises a processing unit configured to pro-cess the received radio signals to detect one or more perturbations.

Optionally, the electrical discharge detector forms an illuminator node configured to transmit at least one of the radio signals to the receiver node.

Optionally, the electrical discharge detector comprises a plug for connection to an outlet of the electrical wiring, and a detection unit for detecting an electrical discharge.

Optionally, the electrical discharge detector is configured to: measure an electrical signal waveform of the electrical wiring, identify one or more transient signals within the waveform; and detect the electrical discharge in dependence on transient characteristics of the one or more transient signals.

In a fourth aspect, there is provided a smart-home system for installation in a premises, the smart-home system comprising: one or more smart devices, and an electrical discharge detector configured to detect electrical discharges in electrical wiring of the premises. The provision of the electrical discharge detector allows the smart-home system to detect electrical discharges which could be precursors of a potential fire. Hence the safety of the premises and any occupants may potentially be improved.

The smart-home system may further be configured to, in response to a detected electrical discharge, transmit a command to at least one of the smart devices instructing the at least one smart device, and in particular at least one smart device connected to the electrical wiring, to be turned off. Hence, a load on the electrical wiring may be reduced upon detection of an electrical discharge, which in turn may reduce the risk of a potential fire arising as a consequence of the detected electrical discharge or any subsequent electrical discharges.

The smart-home system may optionally comprise a smart-home controller configured to transmit the command to the at least one smart device. Optionally, the one or more smart devices includes one or more smart plugs, one or more smart wall switches, one or more smart-home appliances, one or more smart luminary devices, one or more smart home entertainment devices, one or more smart security monitoring sensors, or any combination of one or more thereof.

Optionally, the system is further configured to: determine a section of electrical wiring affected by a detected electrical discharge, identify one or more smart devices connected to the affected section, and transmit a command to the one or more identified smart devices instructing the at least one smart device to be turned off. The load on an affected section of electrical wiring may accordingly be reduced, while smart devices connected to other sections of electrical wiring may still be kept turned on and functional.

Optionally, the smart-home system comprises a plurality of electrical discharge detectors. The plurality of electrical discharge detectors allows a determination to be made of where in an electrical wiring the electrical discharge is likely to have occurred.

Optionally, the electrical discharge detector comprises: a plug for connection to an outlet of the electrical wiring, a detection unit for detecting an electrical discharge, and a communication module for transmitting a detection signal to the smart-home system. The electrical discharge detector may accordingly be easily installed without the need for an electrician.

Optionally, the electrical discharge detector is configured to: measure an electrical signal waveform of the electrical wiring, identify one or more transient signals within the waveform; and detect the electrical discharge in dependence on transient characteristics of the one or more transient signals. It will be appreciated, however, that embodiments include any electrical discharge detection method.

### BRIEF DESCRIPTION OF THE DRAWINGS

In order to best describe the manner in which the above-described embodiments are implemented, as well as define other advantages and features of the disclosure, a more particular description is provided below and is illustrated in the appended drawings. Understanding that these drawings depict only exemplary embodiments of the invention and are not therefore to be considered to be limiting in scope, the examples will be described and explained with additional specificity and detail through the use of the accompanying drawings in which:
- Fig. 1a: is a schematic view of a security monitoring system according to embodiments;
- Fig. 1b: is a block diagram of a security monitoring system according to embodiments of the invention;
- Fig. 2: is a schematic view of an electrical discharge detector according to embodiments;
- Fig. 3: is a flowchart of an electrical discharge detection method according to embodiments;
- Fig. 4: is a flowchart of a method of operating a security monitoring system according to embodiments;
- Fig. 5: is a flowchart of a method of operating a security monitoring system according to embodiments;
- Fig. 6: is a flowchart of a method of operating a security monitoring system according to embodiments;
- Fig. 7: is a flowchart of a method of operating a security monitoring system according to embodiments;
- Fig. 8: is a flowchart of a method of operating a security monitoring system according to embodiments;
- Fig. 9: is a flowchart of a method of operating a security monitoring system according to embodiments;
- Fig. 10: is a method according to embodiments of determining, by a security monitoring system, if anyone is present within a building;
- Fig. 11: is a method according to embodiments of determining, by a security monitoring system, if anyone is present within a building;
- Fig. 12: is a method according to embodiments of determining, by a security monitoring system, if anyone is present within a building
- Fig. 13: is a schematic view of a radio-based sensing arrangement according to embodiments;
- Fig. 14a: is a schematic illustration of the principle underlying radio-based sensing;
- Fig. 14b: is a schematic illustration of the principle underlying radio-based sensing;
- Fig. 15: is a schematic view of a smart-home system according to embodiments;
- Fig. 16: is a flowchart of a method of operating a smart-home system and/or a security monitoring system according to embodiments; and
- Fig. 17: is a flowchart of a method of operating a smart-home system and/or a security monitoring system according to embodiments.

Further, in the figures like reference characters designate like or corresponding parts throughout the several figures.

### DETAILED DESCRIPTION

Various embodiments of the disclosed methods and arrangements are discussed in detail below. While specific implementations are discussed, it should be understood that this is done for illustration purposes only. A person skilled in the relevant art will recognize that other components, configurations, and steps may be used without parting from the spirit and scope of the claimed invention.

Hereinafter, certain embodiments will be described more fully with reference to the accompanying drawings. It will be apparent to those skilled in the art that various modifications and variations can be made without departing from the inventive concept. Other embodiments will be apparent to those skilled in the art from consideration of the specification and practice disclosed herein. It is to be understood that elements and materials may be substituted for those illustrated and described herein, parts and processes may be reversed or omitted, certain features may be utilized independently, and embodiments or features of embodiments may be combined, all as would be apparent to the skilled person in the art.

The embodiments herein are provided by way of example so that this disclosure will be thorough and complete, and will fully convey the scope of the inventive concept, and that the claims be construed as encompassing all modifications, equivalents and alternatives of the present inventive concept which are apparent to those skilled in the art to which the inventive concept pertains. If nothing else is stated, different embodiments may be combined with each other.

Although reference may be made to directions (e.g. left, right, up, down, upper, lower) as shown in the figures, it will be appreciated that these references are purely for illustrative purposes, and that embodiments are not limited to such directions.

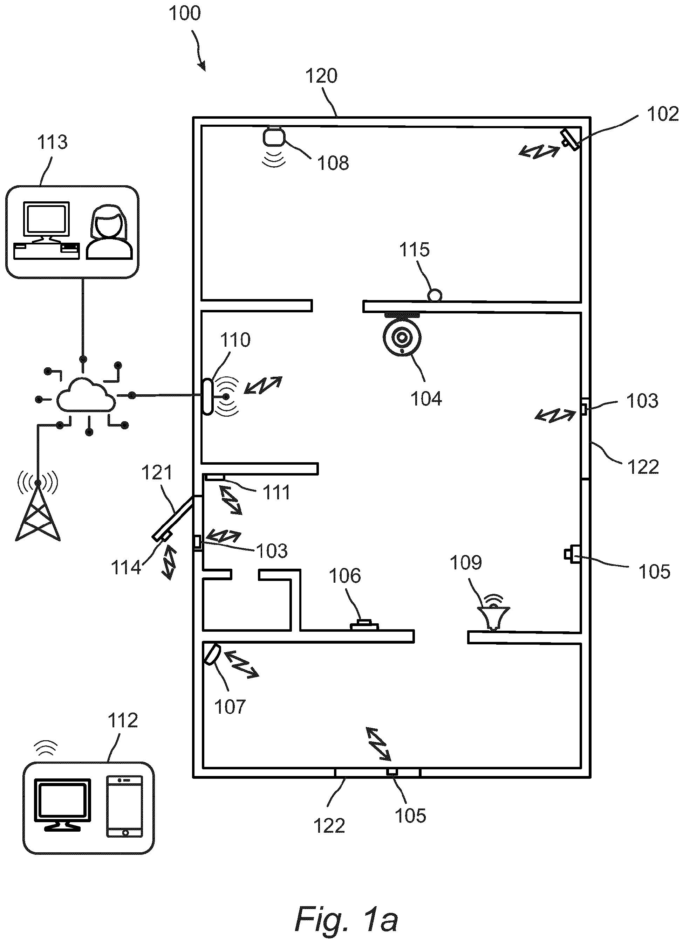

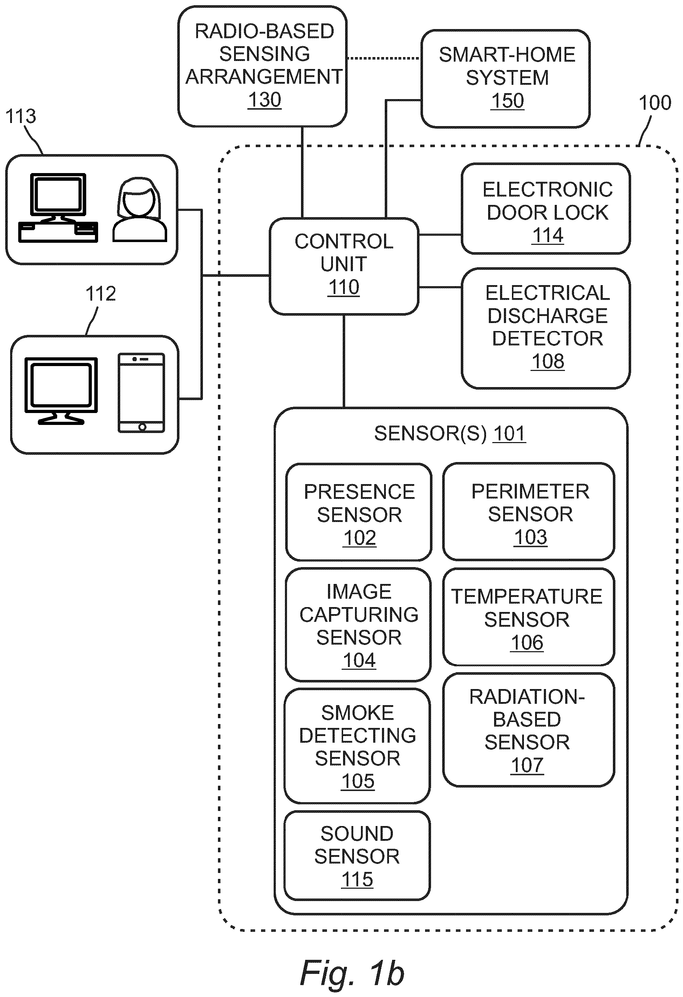

Figs. 1a and 1b show a security monitoring system 100, which may also be referred to as an alarm system, provided in a premises 120, in the form of a building. The premises 120 may be a residential building such as a house or an apartment, and/or a commercial building such as an office building, or the like.

In particular, Fig. 1a shows a plan view of the premises 120, while Fig. 1b shows a block diagram of the security monitoring system 100 which is installed in the premises 120.

The security monitoring system 100 is configured to detect alarm-incurring events (e.g. undesirable security or safety events or hazards), such as an intruder and/or a potential fire or a precursor to a fire.

The security monitoring system 100 comprises one or more sensors 101 for monitoring of the premises 120, for example, an interior or exterior area of the premises 120. While monitoring the premises 120, the sensors 101 are configured to detect an alarm-incurring event, e.g. to make an owner or occupant of the premises 120 aware of the alarm-incurring event.

The security monitoring system 100 may, for instance, include one or more sensors 101 for detecting an intruder entering or moving within the premises 120. Such sensors 101 may comprise one or more presence sensors 102, one or more perimeter sensors 103, one or more image capturing sensors 104, or a combination of any one or more thereof. Additionally, or alternatively, the security monitoring system 100 may include a sensor 101 for detecting a potential fire or precursor to a fire within the premises 120. For example, the security monitoring system 100 may comprise a smoke detecting sensor 105 (i.e. a smoke detector) configured to detect smoke inside the premises 120. The security monitoring system 100 may further comprise one or more temperature sensors 106 for monitoring a temperature within the premises 120, and/or one or more other sensors 101 for monitoring one or more parameters and/or characteristics of the premises 120 or its interior.

A presence sensor 102 may be defined as a sensor 101 sensitive to the presence or movement of persons and/or objects within an area monitored by the presence sensor 102. Presence sensors 102 may thus include motion or passage sensors sensitive to motion or passage of a person and/or object within the premises 120. In particular, any type of sensor or detector capable of detecting presence, and/or movement of a person and/or object, may be used as a presence sensor 102.

For example, the presence sensor 102 may comprise a radiation-based sensor 107 for detecting an amount of incident radiation (such as thermal or infrared radiation), or the like. In particular, the presence sensor 102 may include an infrared sensor such as a thermal-MOS (TMOS) sensor and/or a passive infrared sensor (also referred to as a PIR sensor).

As another example, the presence sensor 102 may comprise a sound sensor 115 such as a microphone configured to monitor and/or detect sounds within the premises 120. It will be appreciated that the sound sensor 115 may be integrated in, or form part of or another component of the security monitoring system 100. For example, there may be a microphone integrated in the image capturing sensor 104, the input means 111 and/or the control unit 110.

Other examples of presence sensors 102 include line-of-sight sensors, optical sensors, visual sensors, thermal sensors, and/or image sensors (e.g. including a camera).

A perimeter sensor 103, on the other hand, may be defined as a sensor 101 configured to detect persons and/or objects crossing or breaching a perimeter of the premises 120 such as person and/or object entering through a door 121 or a window 122. Exemplary perimeter sensors 103 include magnetic sensors arranged at windows 122 and/or doors 121, and/or glass breakage sensors (such as a shock sensor) for detecting breakage of e.g. a window or glass door.

In embodiments, the security monitoring system 100 may comprise at least one sensor 101 comprising image capturing means, such as a camera (e.g. a photographic camera), video camera or any other type of type of optical sensing device capable of capturing or acquiring one or more still and/or moving images. Such a sensor may accordingly be referred to as an image capturing sensor 104. The image capturing sensor 104 is configured to capture one or more images of an area of the premises 120 proximate to where it is located. For instance, the image capturing sensor 104 may capture images of the room in which it is located.

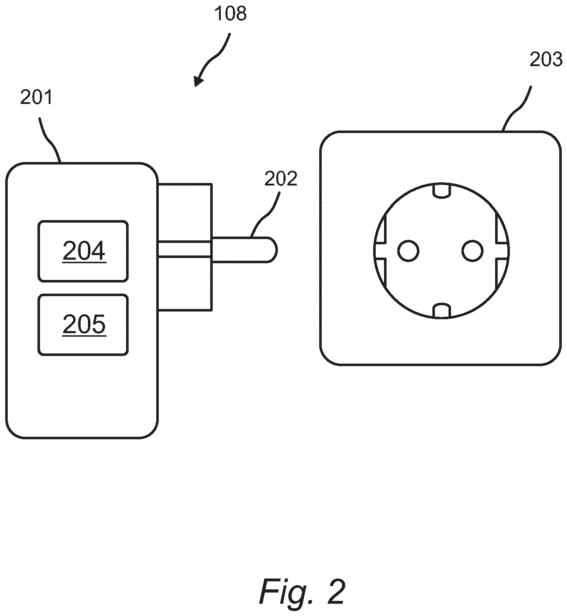

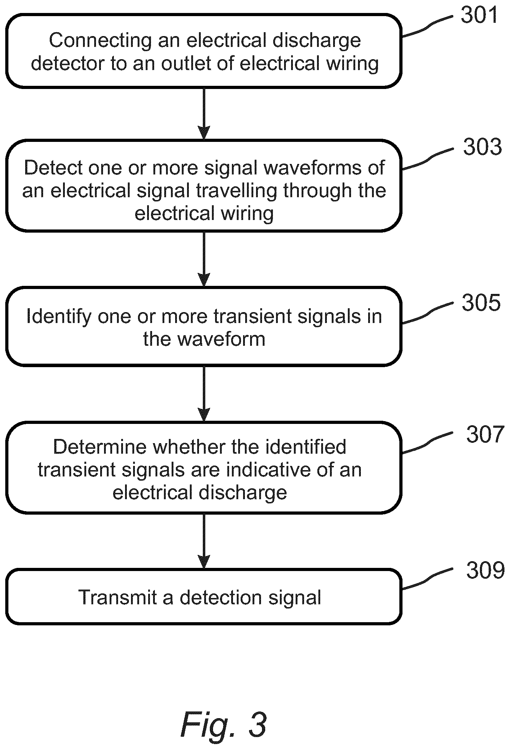

In addition to the above-described sensors 101, the security monitoring system 100 comprises at least one electrical discharge detector 108 for detecting electrical discharges in the electrical wiring of the premises 120. The electrical discharge detector 108 will be described further in relation to Figs. 2 and 3.

The security monitoring system 100 may comprise one or more alarm indicators 109 such as a visual alarm indicator (e.g. a flashing light), an audible alarm indicator (e.g. a siren), or the like, that may be activated in the event of an alarm-incurring event being detected.

The security monitoring system 100 may further comprise a control unit 110 which may also be referred to as a central unit. The control unit 110, which is generally mains powered, is coupled or connected to the sensors 101 and the electrical discharge detector 108, and is configured to process signals received therefrom and determine a response. The sensors 101 and the electrical discharge detector 108 may, for example, be provided with wireless (e.g. via Wi-Fi, radio frequency, or the like) and/or wired communication means for communicating with the control unit 110. In particular, the sensors 101 may be coupled to the control unit 110 using transceivers that may operate in the industrial scientific and medical (ISM) bandwidths, for example a sub-gigahertz bandwidth such as 868 MHz, and the communications may be encrypted preferably using shared secret keys.

The control unit 110 may include a processor and an alert triggering unit for providing an alert signal when the security monitoring system 100 is triggered or set off, e.g. when an alarm-incurring event has occurred.

The control unit 110 may also be connected to input means 111 allowing a user to interact with the control unit 110. The input means 111 may be a keypad or similar, for arming and disarming the sensors 101 so as to arm and disarm the security monitoring system 100. In the illustrated embodiment, the input means 111 is arranged in the vicinity of the entrance door 121. In some embodiments, the input means 111 comprises voice-controlled input means.

The control unit 110 may communicate with one or more user devices 112, which may be almost any kind of electronic device such as a smartphone, tablet, laptop or desktop computer, a smart watch, or even a television. For example, the control unit 110 may communicate with an app or other program installed on such user devices 112 allowing the user to interact with the control unit 110 and/or the security monitoring system 100.

The user device 112 may also be loaded with a public land mobile network (PLMN) by means of which the control unit 110 (and/or a remote monitoring centre 113 as will be described later) may communicate with the user device 112. The user device 112, and in particular the app or program installed thereon, may thus form input means 111 to the control unit 110 such that the user can, through the user device 112, instruct the control unit 110 to arm or disarm the security monitoring system 100, or the like. The user device 112 may also provide the user with information relating to a state of the security monitoring system 100 (e.g. if it is in an armed or disarmed state) and/or of one or more of its sensors 101. The security monitoring system 100 may accordingly notify the user via the user device(s) 112 if and when the security monitoring system 100 is set off or triggered.

The control unit 110 may further be connected to a remote monitoring centre 113, which is located remotely from the premises 120. The control unit 110 may accordingly be configured to transmit alert signals to the remote monitoring centre 113, where operators (i.e. human operators) and/or computerised systems manage the alert signals and determines an appropriate action. That is, the control unit 110, typically located in the premises 120, is configured to process notifications and signals received from the sensors 101 and/or the electrical discharge detector 108, and to notify the remote monitoring centre 113 of at least some of these signals that corresponds to or are indicative of an alarm-incurring event (e.g. an undesirable security or safety event), depending upon the settings of the system and the nature of the detected events. In such a configuration, the control unit 110 at the installation is effectively acting as a gateway between the sensors 101 and the remote monitoring centre 113.

The control unit 110 may be connected to the remote monitoring centre 113 by wires, such as a telephone line, or by a wireless telecommunications system such as GSM or other radio frequency systems. The connection may also be through the internet or any other suitable network.

Hence, operation of the security monitoring system 100 may be controlled by one or more of: the control unit 110, the remote monitoring centre 113, and a security monitoring app installed on a user device 112. For example, the remote monitoring centre 113, if provided, may receive one or more signals from any of the sensors 101 and/or the electrical discharge detector 108. The remote monitoring centre 113 may transmit commands for controlling any one or more of: the arm state of the security monitoring system 100 (e.g. armed or unarmed), commanding a tripped alarm state to be signalled by the security monitoring system 100 (e.g. by triggering one or more alarm indicators to generate alarm noise), commanding operation of one or more functions of the sensors 101 and/or electrical discharge detector 108. Communication with the remote monitoring centre 113 may pass through the control unit 110. In other embodiments without the remote monitoring centre 113, or should communication with the remote monitoring centre 113 be interrupted, operation of the security monitoring system 100 may be controlled by the control unit 110. In yet other embodiments, the control unit 110 may be omitted, and the sensors 101 and/or the electrical discharge detector 108 may instead communicate independently with the remote monitoring centre 113, for example, via wireless communication (such as Cat-M LTE).

Howsoever the communication is implemented, the remote monitoring centre 113 may alert one or more operators of an alarm-incurring event. The one or more operators may monitor communications received from the security monitoring system 100. Thus, the one or more operators may, in response to an alert signal being transmitted, send a patrol unit and/or the emergency services to the premises 120 and/or notify an owner or resident of the premises 120.

The security monitoring system 100 may further include one or more electronic door locks 114 (such as electronic smart locks) for providing and/or controlling a locking mechanism of a door 121. Hence, the locking mechanism at the door 121 may be electrically opened and closed so as to unlock or lock the door 121. The electronic door lock 114 may communicate with the control unit 110 and/or one or more user devices 112, e.g. to transmit instructions from a user to lock or unlock the door 121. Alternatively, additionally, the electronic door lock 114 may be locked/unlocked by placing a key fob or the like in the vicinity of the electronic door lock 114 or an associated key fob panel. The electronic door lock 114 may additionally be configured to transmit information about a state of the electronic door lock 114 to the control unit and/or the user device 112 (e.g. information about whether the electronic door lock 114 is in a locked or unlocked state).

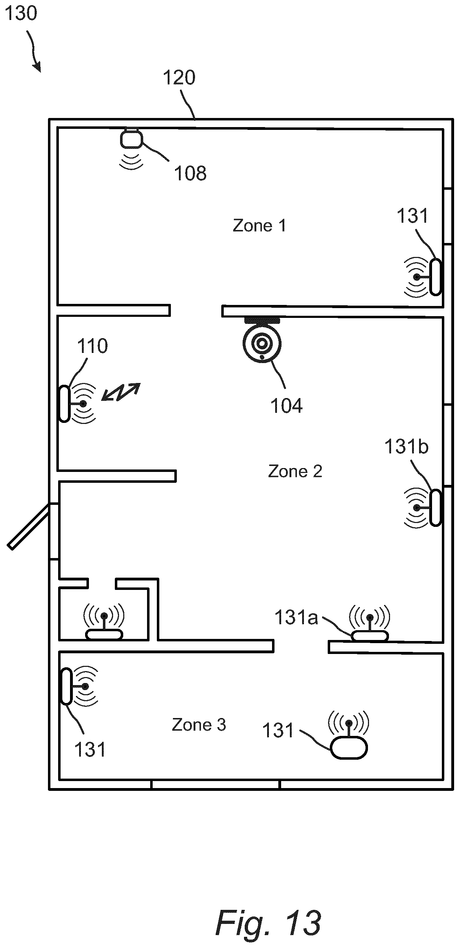

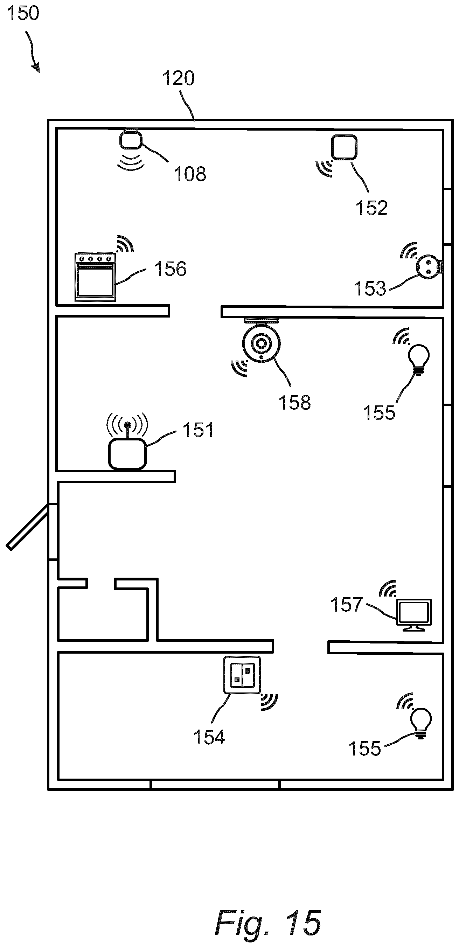

As shown in Fig. 1b, the security monitoring system 100, and in particular the control unit 110, may be connected to a radio-based sensing arrangement 130 and/or a smart-home system 150, as will be described later in relation to Figs. 13 and 15 respectively.

Fig. 2 shows a schematic view of the electrical discharge detector 108. The electrical discharge detector 108 is configured to detect electrical discharges occurring in electrical wiring of a premises 120.

The electrical discharge detector 108 comprises a detection unit 201, and a plug 202 for connection to an electrical outlet 203 (e.g. a socket) of electrical wiring of the premises.

The plug 202 is configured to electrically couple the detection unit 201 to the electrical wiring of the premises 120, while the detection unit 201 is configured to measure an electrical signal of the electrical wiring at the location where the electrical discharge detector 108 is connected.

Here it is noted that the electrical discharge detector 108 is intended to be connected directly to the electrical wiring by insertion of the plug 202 into a standard electrical outlet 203. The electrical discharge detector 108 may accordingly be installed without the need for an electrician.

The detection unit 201 may comprise a processing module 204 and a communication module 205. The processing module 204 may comprise signal measuring means for measuring the electrical signals travelling through the electrical wiring as waveform data, a signal converter such as an analog-to-digital signal converter, a signal amplifier, and/or one or more filters for filtering out 50Hz and/or 60Hz signals and/or electrical noise generated by appliances and devices connected to the electrical wiring. The filters and/or amplifiers may be achieved using hardware and/or software.

In some embodiments, at least part of the processing is performed remotely from the electrical discharge detector 108. That is, the electrical discharge detector 108 may be configured to transmit the measured electrical signal to a remotely located processor which may be configured to process and analyse the received electrical signal.

The communication module 205 allows the electrical discharge detector 108 to communicate with other devices, and in particular with the security monitoring system 100, the control unit 110, the remote monitoring centre 113, one or more user devices 112, the emergency services, the radio-based sensing arrangement 130 and/or the smart-home system 150.

The communication module 205 may comprise wired or wireless communication means. For instance, the communication module 205 may comprise a radio transmitter or transceiver configured to communicate over any known radio communication protocol including a Wi-Fi protocol, such as the IEEE 802.11 standard, a Bluetooth protocol, and/or a protocol using single-sideband channel communication, optionally one operating on an ISM band such as the European 863MHz to 870MHz frequency band (e.g. around 868MHz).

As part of communication related to the radio-based sensing arrangement 130, the communication module 205 may be configured to transmit and/or receive radio signals. The electrical discharge detector 108 can accordingly function as a node in the radio-based sensing arrangement 130. That is, when functioning as a node of the radio-based sensing arrangement 130, the electrical discharge detector 108 is configured to transmit and/or receive radio signals which are used to perform radio-based sensing throughout the premises 120. In particular, the communication module 205 may comprise a radio transmitter for transmitting one or more radio signals. The electrical discharge detector 108 can accordingly serve as an illuminator node of the radio-based sensing arrangement 130. Optionally, the communication module 205 may comprise a radio transceiver allowing the electrical discharge detector 108 to both transmit and receive such radio signals. The electrical discharge detector 108 can accordingly serve as an illuminator node and/or a receiver node of the radio-based sensing arrangement 130. The radio transmitter or transceiver may be a Wi-Fi transmitter or transceiver configured to transmit and/or receive Wi-Fi signals. In other words, the Wi-Fi transmitter or transceiver may be configured to use a Wi-Fi protocol, such as the IEEE 802.11 standard. Hence, the electrical discharge detector may be used as a node in a radio-based sensing arrangement 130 which is based on Wi-Fi signals.

In some embodiments, the electrical discharge detector 108 may comprise a first and a second communication module. The first communication module may be configured to perform communication related to the radio-based sensing arrangement 130 while the second communication module may be configured to perform other communication, such as communication with the security monitoring system 100.

In particular, the first communication module may operate on a radio communication protocol with a relatively high energy demand which is necessary to perform the radio-based sensing. For instance, the first communication module may comprise a Wi-Fi transmitter or transceiver configured to use a Wi-Fi protocol, such as the IEEE 802.11 standard.

The second communication module, on the other hand, may be configured to communicate via wired or wireless communication means. For instance, the second communication module may comprise a second (i.e. a separate) transceiver for transmitting signals to and/or receiving signals from the security monitoring system 100. The second transceiver may be configured to operate on a protocol with a relatively lower energy demand. In other words, the second transceiver preferably has low energy consumption and hence is configured to use a protocol, other than one according to any of the IEEE 802.11 standards, and preferably one using single-sideband channel communication, optionally one operating on an ISM band such as the European 863MHz to 870MHz frequency band (e.g. around 868MHz). The first transceiver may for example use a protocol such as BLE, Matter, or another low energy protocol that uses an ISM channel. Thus, the electrical discharge detector 108 can communicate with the security monitoring system 100 without requiring excessive power, while still being able to perform high-power tasks related to radio-based sensing when required.

The electrical discharges typically occur when the integrity of an electrical wire or its insulation is compromised. For example, the electrical wire or its insulation may be damaged (e.g. physical damage, and/or water damage), corroded, aged, or the like, or one or more connections between the electrical wire and another electrical component may have come loose. Such damage may lead to sporadic electrical discharges within the wire and/or between the wire and another electrical conductor.

As the electrical discharges continue over time, the damage or erosion to the insulation or other materials surrounding the wire is worsened, increasing the intensity of the electrical discharges. Hence, after sufficient time has passed, the electrical discharges may become high-power, continuous and high-temperature discharges which may eventually result in the ignition of a spark or fire in the material in which the electrical wiring is arranged which is often combustible (e.g. wood and/or insulation in the walls of the premises).

It is accordingly important to detect electrical discharges in electrical wiring as early as possible to reduce the risk of a fire. Hence, by detecting electrical discharges, a user (e.g. the occupant or owner of the premises 120) and/or emergency services can be alerted to the faulty electrical wiring, hopefully in time to prevent a fire from starting and/or put out a fire at an early stage.

The electrical discharge detector 108 can detect electrical discharges by monitoring the electrical signals travelling through the electrical wiring. As the electrical discharges give rise to a sharp electromagnetic impulse (e.g. an impulse of current), the electrical discharge detector 108 is configured to identify any impulses likely to originate from an electrical discharge.

Upon detection of an electrical discharge, the electrical discharge detector 108 may be configured to notify a user (e.g. an occupant or owner of the premises 120) of the detected electrical discharge. The electrical discharge detector 108 may accordingly comprise one or more notification means, e.g. comprising visual notification means (e.g. a flashing light), audible notification means (e.g. a siren), or the like.

Alternatively, or additionally, the electrical discharge detector 108 may be configured to send a detection signal to the security monitoring system 100, the radio-based sensing system 130 and/or the smart-home system 150 installed in the premises 120. In some embodiments, the electrical discharge detector 108 may additionally or alternatively send a detection signal to one or more other devices, such as one or more sensors 101, one or more smart devices of the smart-home system 150, a user device 112 and/or a device of the remote monitoring centre 113.

The electrical discharge detector 108 may be configured to detect electrical discharges by the method of Fig. 3. It will be appreciated that the detection method of Fig. 3 is purely exemplary, and embodiments also include detection of electrical discharges by any other suitable method.

In step 301, the electrical discharge detector 108 is connected to an outlet 203 of the electrical wiring of the premises 120. This connection is usually performed when the electrical discharge detector 108 is first installed in the premises 120, after which the electrical discharge detector 108 typically remains connected to the outlet 203.

In step 303, the electrical discharge detector 108 senses or detects an electrical signal travelling through the electrical wiring of the premises 120. In particular, the electrical discharge detector 108 captures one or more signal waveforms (e.g. voltage and/or current waveforms) generated by electrical activity in or connected to the electrical wiring.

In step 305, the electrical discharge detector 108 identifies one or more transient signals in the waveform. Because electrical discharges involve an impulse change in current (as explained previously), the electrical signal generated or caused by said electrical discharge is transmitted along the electrical wiring which can be identified by the electrical discharge detector 108 as transient signals. Accordingly, the electrical discharge detector 108 is configured to detect a change in the signal waveform data in order to identify one or more transient signals in the waveform. The identification of transient signals may be performed using any known method or process, including but not limited to processes involving binning of sampled waveform data, use of floating thresholds of samples in the waveform data, calculation of derivates and/or maximums, or the like.

In step 307, the electrical discharge detector 108 analyses the identified transient signals to determine whether the identified transient signals are indicative of an electrical discharge. For example, the electrical discharge detector 108 may generate and analyse one or more transient characteristics in dependence on the identified transient signals. The generation of transient characteristics may be performed using any known method or process, including but not limited to, methods involving calculating the average transient amplitude over a full voltage cycle and/or for phase sections within the voltage cycle, calculating the amplitude, pulse width, integral and/or rise time of peaks of the transient, or the like.

In analysing the transient characteristics, the electrical discharge detector 108 may identify one or more electrical discharge indicators in the transient characteristics, for example by comparing the transient characteristics to reference data and characteristics, and/or data associated with previously detected electrical discharges, which may be stored in a memory of the electrical discharge detector 108.

As an example, the electrical discharge detector 108 may reconstruct the signal waveform using the generated transient characteristics and compare the distribution of transients in the reconstructed waveform to an expected or reference transient distribution. Here it is noted that the transient signals generated by an electrical discharge travel along the electrical wiring being reflected at any junction. The signals caused by the electrical discharge experience a delay in returning which is dependent on the length of the wire, as well as exhibiting a phase shift.

Hence, if the comparison shows that the transients occur in phase and/or in a regular or repeatable pattern, the transients are likely a result of (normal) operation of a device or appliance connected to the electrical wiring. Alternatively, if the comparison shows that the transients are out of phase and/or in an irregular pattern, this indicates that the transients are a likely result of one or more electrical discharges.

As another example, the electrical discharge detector 108 may compare the generated transient characteristics to reference characteristics data and/or reference characteristics thresholds using any known or suitable method. For instance, the electrical discharge detector 108 may determine the average peak ratio of transients in phase sections of the voltage cycle close to maximum voltage to transients in phase sections of the voltage cycle close to zero voltage, and compare the determined ratio with a threshold value where, if the ratio is above the threshold value, the transient signals are determined as being indicative of an electrical discharge. As another example, the electrical discharge detector 108 may determine if the number of peaks in the transient exceeds a threshold and/or if the rise time for the one or more of the peaks is greater than a threshold. If so, the transient may be determined to be indicative of an electrical discharge.

In some embodiments, the electrical discharge detector 108 may calculate a likelihood value of an electrical discharge having occurred, for example in dependence on how irregular and/or out of phase the transient signals are and/or how far above/below the characteristics are from one or more thresholds. The likelihood value may then be compared to a threshold value to determine whether an electrical discharge has been detected.

In some embodiments, the analysis of transient characteristics may be improved by machine learning techniques, e.g. for determining appropriate threshold levels and/or appropriate reference data.

Once a transient signal has been determined to be indicative of an electrical discharge, i.e. when a likely electrical discharge has been detected, the electrical discharge detector 108 may transmit a detection signal in step 309.

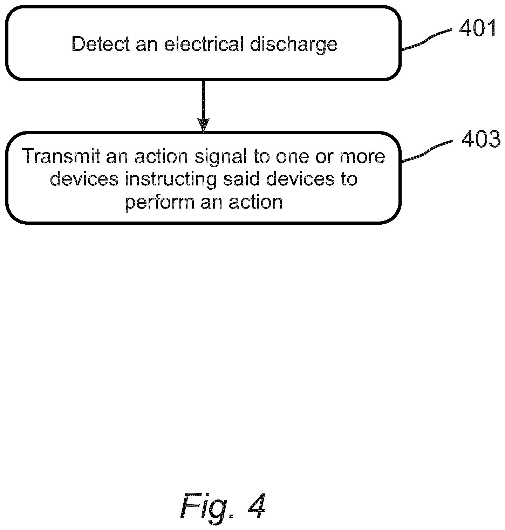

Fig. 4 shows a method of operating the security monitoring system 100 in response to the detection of an electrical discharge by the electrical discharge detector 108.

In step 401, an electrical discharge is detected. The electrical discharge may be detected by the electrical discharge detector 108 which may detect the electrical discharge according to the method of Fig. 3 or any other suitable method.

In step 403, one or more action signals are transmitted, in response to the detected electrical discharge, to one or more devices instructing the one or more devices to perform one or more actions.

The action signal(s) may be transmitted in response to receiving a detection signal from the electrical discharge detector 108. For example, the security monitoring system 100 (e.g. the control unit 110) and/or the remote monitoring centre 113 may receive the detection signal from the electrical discharge detector 108 and transmit the action signal in response thereto. In such a scenario, the method of Fig. 4 may comprise the steps of: (i) detecting an electrical discharge; (ii) transmitting a detection signal to the security monitoring system 100 and/or the remote monitoring centre 113; (iii) in response to the detection signal, transmitting, by the security monitoring system 100 and/or the remote monitoring centre 113, one or more action signals to one or more devices instructing said devices to perform one or more actions.

Alternatively, or additionally, the action signal(s) may be transmitted directly from the electrical discharge detector 108.

The action signal(s) may be transmitted to one or more sensors 101, the electronic door lock 114, one or more devices of the remote monitoring centre 113, one or more user devices 112, one or more devices of the radio-based sensing arrangement 130, one or more devices of the smart-home system 150, and/or any other device(s) part of or communicatively connected to the security monitoring system 100.

The actions may include actions relating to increasing an alertness and/or a potential fire detection or prevention performance of the security monitoring system 100. The actions may additionally or alternatively include actions relating to reducing a load on the electrical wiring of the premises 120. Examples of such actions will be described in relation to the following figures.

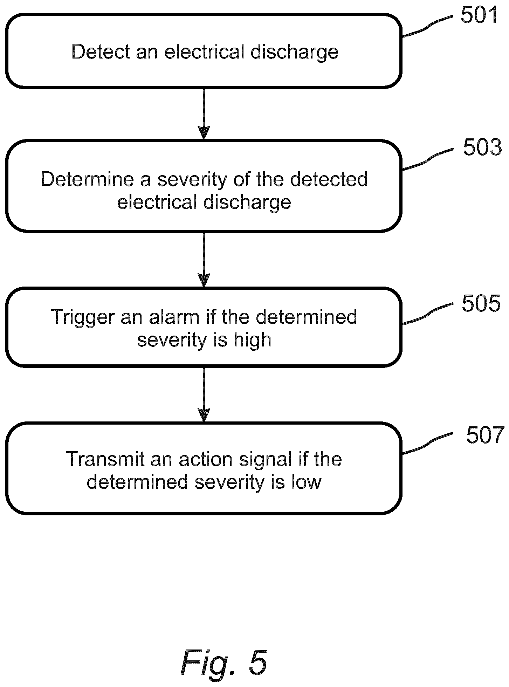

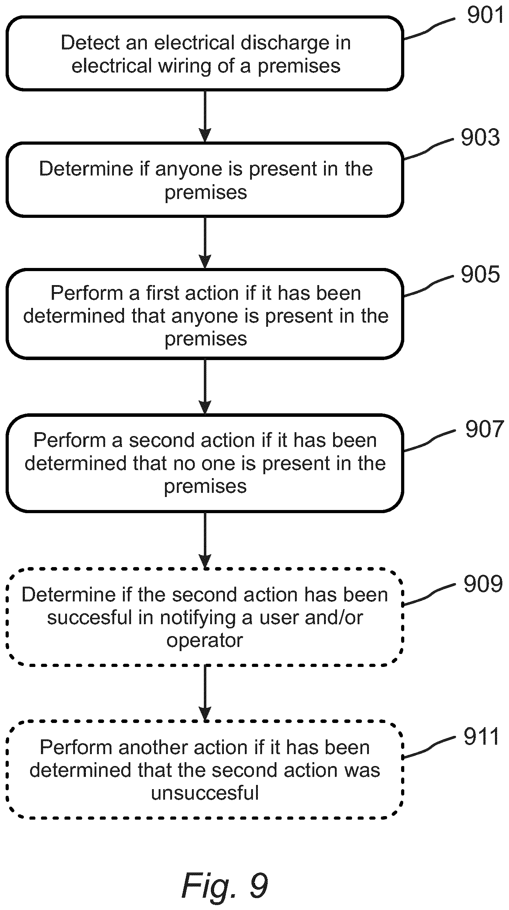

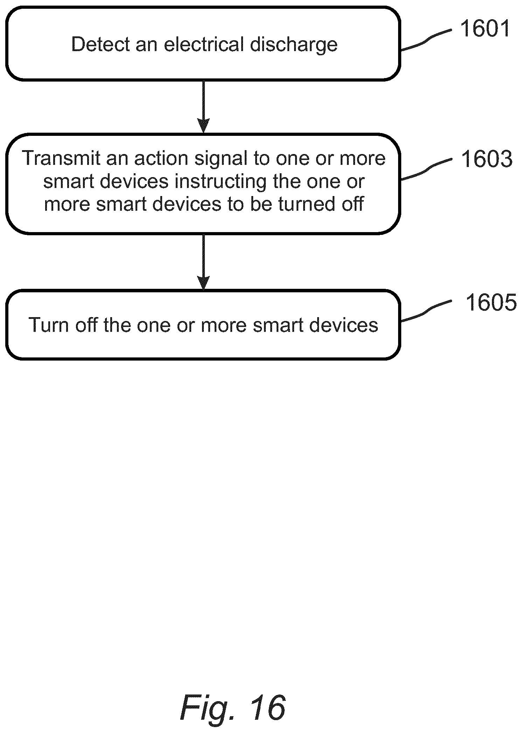

In particular, the actions may include (i) altering a sensor state as described in relation to Figs. 5 to 8, (ii) determining of presence within the premises 120 (for example as described in relation to Figs. 9 to 12 and/or using the radio-based sensing arrangement 130), (iii) monitoring the premises 120 (e.g. by one or more sensors 101 and/or by an operator at the remote monitoring centre 113), (iv) requesting a user (e.g. via a notification transmitted to a user device 112) to provide an input, (v) contacting (for example by an operator at the remote monitoring centre 113) an occupant or resident of the premises 120, (vi) triggering an alarm indicator 109 such as a siren, (vii) turning off one or more smart-devices of the smart-home system 150 as described in relation to Figs. 16 to 17, (viii) notifying emergency services, or any combination thereof.

Fig. 5 shows a further method of operating the security monitoring system 100 in which a severity of a detected electrical discharge is determined. The security monitoring system 100 may be configured to take action in dependence on the determined severity of the detected electrical discharge. For example, if the determined severity exceeds a threshold, the security monitoring system 100 may directly trigger an alarm indicator 109 (e.g. a siren) within the premises 120 to notify occupants of the electrical discharge and/or the security monitoring system 100 may directly notify the emergency services. Conversely, if the determined severity is below the threshold, the security monitoring system 100 may transmit one or more action signals to one or more devices.

In step 501, an electrical discharge is detected, e.g. by the electrical discharge detector 108. The detection in step 501 is substantially equivalent to the detection as described in relation to step 401 of Fig. 4.

In step 503, the system is configured to determine a severity of the detected electrical discharge.

For example, the electrical discharge detector 108 may compare the transient characteristics of the identified transient signal to reference characteristics (e.g. previously detected electrical discharges) for electrical discharges with varying or different severity. Further, any machine learning techniques used in analysing the transient characteristics may be trained on data for electrical discharges of different severity allowing the analysing techniques to determine whether the identified transient signal corresponds to, e.g. an electrical discharge of relatively low severity or of relatively high severity.

Alternatively, or additionally, the electrical discharge detector 108 may infer the severity of an electrical discharge from the frequency and/or number of detected electrical discharges. For example, if the electrical discharge detector detects several electrical discharges over a period of time, it may be inferred that a later electrical discharge has higher severity than an earlier electrical discharge (because the fault in the electrical wiring causing the electrical discharges is likely to become worse over time). Accordingly, the electrical discharge detector 108 may be configured to infer that the severity is high after a predetermined number of electrical discharges have been detected within a set time frame.

In step 505, an alarm is triggered in dependence on the severity of the detected electrical discharge exceeding a threshold. The triggering of the alarm may involve setting off a siren and/or other alarm indicator 109 in the premises 120, and/or notifying the emergency services.

If the determined severity is instead below the threshold, one or more action signals may be transmitted in step 507 (which substantially corresponds to step 403 of Fig. 4). In some embodiments, step 507 may also be performed when the severity of the electrical discharge is high. In other words, step 507 may be performed in addition to the triggering of the alarm in step 505 when the severity is high.

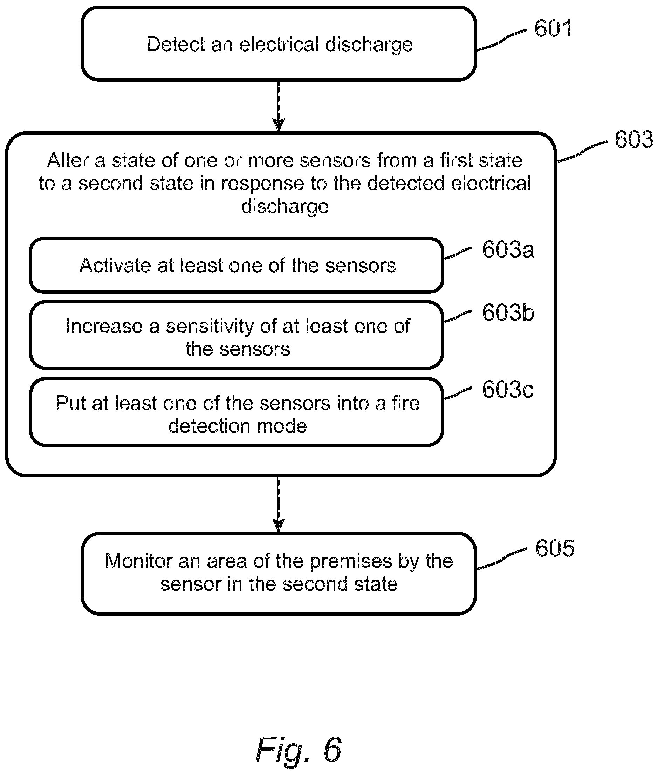

Fig. 6 shows an exemplary method of operating the security monitoring system 100 where the one or more actions performed in response to the electrical discharge detection includes altering of a sensor state.

In particular, the security monitoring system 100 may alter a state of one or more of its sensors 101 (e.g. one or more sensors 101 monitoring an interior area of the premises 120) in response to the detection of the electrical discharge.

It is noted that the electrical discharge detector 108 is generally active irrespective of whether the security monitoring system 100 is in an armed or disarmed state (i.e. the electrical discharge detector 108 is substantially always active), and the security monitoring system 100 may accordingly alter the state of the sensors 101 even if the system is in a disarmed state (e.g. if occupants are in the premises 120) where the sensors 101 are not normally active. This is of particular importance considering that fires in the premises 120 are most dangerous when occupants are present in the premises 120 and the security monitoring system 100 accordingly is disarmed.

The security monitoring system 100 can accordingly (i) be made even more alert in case a fire breaks out so as to further improve potential fire detection performance, (ii) focus the sensors 101 primarily on fire or spark recognition or detection, and/or (iii) reduce the risk of unnecessarily calling the emergency services. Hence, a risk of a devastating fire event may potentially be reduced.

In step 601, the electrical discharge detector 108 detects a likely electrical discharge which could be a precursor to a fire. The electrical discharge detector 108 may detect the electrical discharge according to the method of Fig. 3 or any other suitable method. The detection in step 601 is substantially equivalent to the detection in step 401 of Fig. 4 or step 501 of Fig. 5.

In step 603, a state of one or more sensors 101 of the security monitoring system 100 is altered in response to the detected electrical discharge. The state may be altered from a first state (e.g. a default state and/or disarmed state) to a second state. The second state may be a state where an alertness level of the sensor 101 is increased.

The one or more sensors 101 that are altered may be any sensor 101 previously described in relation to the security monitoring system 100 or any other sensor 101 part of or connected to the security monitoring system 100.

The sensor(s) 101 may be configured to alter their state upon receiving an action signal. The action signal may be transmitted directly from the electrical discharge detector 108 in response to the detection of the electrical discharge. Alternatively, or additionally, the sensor(s) 101 may receive the action signal from the control unit 110 and/or the remote monitoring centre 113 instructing the sensor(s) 101 to alter their state (e.g. in response to the control unit 110 and/or the remote monitoring centre 113 receiving a detection signal from the electrical discharge detector 108).

In step 605, the one or more sensors 101 in the altered state may be configured to provide (enhanced) monitoring of an area (e.g. an interior area) of the premises 120. Hence, the sensors 101 in the altered state may allow detection of a potential fire (and/or a precursor to a fire) in the premises 120. Accordingly, a potential fire detection performance of the security monitoring system 100 is improved. The monitoring may be performed by the sensor 101 in the second state directly. The monitoring may alternatively or additionally be performed elsewhere in dependence on monitoring data transmitted from the sensor 101 in the second state, e.g. by an operator (e.g. located at the remote monitoring centre 113) and/or automatically (e.g. by a processor of the control unit 110).

If the monitoring by the sensor 101 in the second state indicates that a potential fire may have started in the premises 120, an alert signal may be generated and transmitted. The alert signal may be transmitted to the control unit 110, the remote monitoring centre 113 (e.g. via the control unit 110), one or more user devices 112, and/or directly to the emergency services (e.g. the fire brigade). In response to the alert signal, an alarm may be raised. For example, a siren or other alarm indicator 109 in the premises 120 may be triggered.

If, on the other hand, it is determined that the detection of an electrical discharge was a false alarm (i.e. a false positive), the sensor 101 may revert to the original state without transmitting an alert signal. Similarly, if the cause of the electrical discharge is identified and resolved (e.g. by a qualified electrician), the sensor 101 may revert to its original state.

The altering of a sensor state in step 603 may comprise any one or more of the sub-steps 603a, 603b, and/or 603c.

In step 603a, the one or more sensors 101 are activated, turned on, or woken up. In other words, the altering of the sensor state comprises activating, waking up and/or turning on the one or more sensor 101. For example, the sensor 101 may be woken up or activated from a sleep state, a turned off state, or a disarmed state.

The sensor 101, once activated, may be configured to monitor an area of the premises and/or to transmit monitoring data to the control unit 110, the remote monitoring centre 113, and/or a user device 112 following the detected electrical discharge. Hence, an alertness and/or potential fire detection performance of the security monitoring system 100 may be increased, and the emergency services may, if necessary, be notified at an appropriate time.

For example, an image capturing sensor 104 (e.g. a sensor 101 comprising a photographic and/or video camera) may be activated in step 603a so as to provide and/or obtain one or more (still and/or moving) images of its field of view. Generally, the image capturing sensor 104 may only capture images in response to a presence sensor 102 (such as a PIR sensor) detecting a potential intruder in the premises 120, however, the security monitoring system may in step 603a force the image capturing sensor 104 to enter an activated state.

The images provided (e.g. captured or obtained) by the image capturing sensor 104 may be transmitted to a user (e.g. to an app on a user device 112) such that the user (who may not be present in the premises 120) can view the images to monitor if a fire has started in the premises 120. The images may alternatively or additionally be sent to the remote monitoring centre 113 for visual monitoring of the premises 120. For instance, an operator at the remote monitoring centre 120 may monitor the images to see if a potential fire has started and/or an image analyser may be used to analyse the images to determine if a potential fire has started. In some embodiments, the image capturing sensor 104 may provide a live feed of the premises 120 which may be viewed and/or analysed, e.g. by a user or operator.

As another example, a radiation-based sensor 107 (e.g. a thermal radiation-based sensor or a photosensor such as an infrared sensor, e.g. PIR sensor) may be activated. Such a sensor 101 may be used to monitor an amount an incident infrared light (or other thermal radiation). Similarly, a temperature sensor 106 may be activated to monitor the temperature within the premises 120. The amount of incident thermal radiation and/or the temperature may be indicative of whether a potential fire has started. Measurements and/or readings from the sensors 101 may be transmitted to the security monitoring system 100 where monitoring may be performed by operators and/or automatically. It is noted that the temperature sensor 106 may otherwise only be active (and/or configured to transmit readings) upon request by a user (e.g. whenever the user opens the app on a user device 112 to check the temperature inside the premises 120).

In step 603b, which may be performed in addition to or separately from step 603a, a sensitivity of the one or more sensors 101 is increased. In other words, the sensor 101 is altered to a state in which the sensor 101 has a higher sensitivity. For example, the sensor 101 may be altered from a low-sensitivity, default, armed, disarmed and/or inactivated state into a high-sensitivity state.

As an example, a sensitivity level of a smoke detecting sensor 105 (which is generally always active) may be altered such that the smoke detecting sensor 105 has an increased sensitivity to smoke. For example, a smoke detection threshold for triggering an alarm may be decreased. Hence, the smoke detecting sensor 105 may provide an alert signal (e.g. by sirens or the like) even if only a small amount of smoke is detected.

In step 603c, which may be performed in addition to or separately from steps 603a and/or 603b, one or more sensors 101 are put into a fire detection mode. For example, the sensor 101 may be altered from a default, armed, disarmed and/or inactive state and put into the fire detection mode. In the fire detection mode, the sensors 101 may be specifically configured to prioritise data (e.g. input data or monitoring data) that may be indicative of a potential fire in the premises.

As an example, an image capturing sensor 104 (e.g. a photographic or video camera) may be put into the fire detection mode. In the fire detection mode, the image capturing sensor 104 may provide monitoring of its field of view to determine whether one or more colours present in the images are indicative of a potential fire in the field of view of the image capturing sensor 104. For example, the image capturing means may be configured to capture (still or moving) images comprising colour data. As another example, the image capturing sensor 104 may provide a live feed of its field of view, which can be used to determine if target colour(s) are (sufficiently) present. The security monitoring system 100 can accordingly alert occupants (e.g. through a siren) as well as the remote monitoring centre 113 and/or the emergency services when a potential fire is detected.

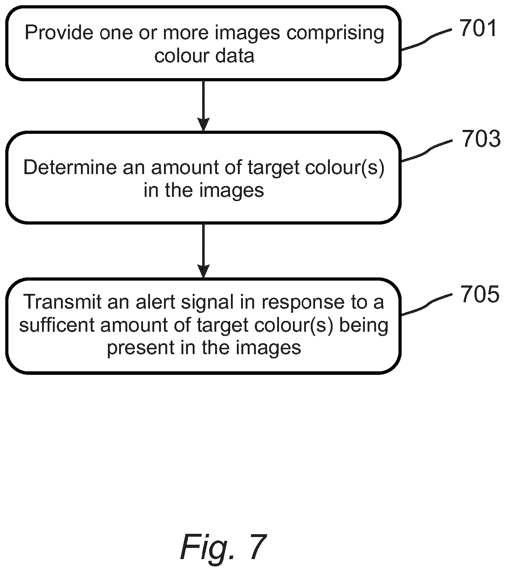

In particular, a method of operating the security monitoring system 100 with image capturing sensor 104 in fire detection mode is shown in Fig. 7. The method of Fig. 7 may be performed after the image capturing sensor 104 has been put into a fire detection mode in step 603c of Fig. 6.

In step 701, the image capturing sensor 104 may provide (e.g. capture) one or more (still and/or moving) images comprising colour data. The images may represent the field of view of the image capturing sensor 104. The image capturing sensor 104 may be configured to provide or capture images over a period of time (e.g. continuously, at regular intervals or the like) to allow monitoring of the premises over an extended period of time. In some embodiments, the images are provided in the form of a video recording and/or a live feed.

In particular, the one or more images representing the field of view of the image capturing sensor 104 may comprise colour data relating to one or more target colours. The target colours may include colours that are indicative of fire potentially being present in the image or field of view. For example, the target colours may include red, yellow and/or orange.

In some embodiments, the image capturing sensor 104 is, in the fire detection mode, configured to be more sensitive to one or more target colours (e.g. red, orange and/or yellow wavelengths) than to one or more other colours (e.g. blue or green wavelengths).

In step 703, it is determined whether an amount of one or more target colours in the image(s) indicates that there is a potential fire in the premises 120. For instance, the system may determine whether an amount of one or more target colours is higher than a threshold. The threshold may be set in dependence on colour data of one or more reference images (e.g. image(s) taken previously by the image capturing sensor 104). Accordingly, the amount of target colours may be compared to colour data of one or more reference images to determine if a potential fire may have started in the premises 120. As another example, the system may determine whether an amount of one or more target colours increases (e.g. a sudden increase and/or an increase by a predetermined amount).

The determination may be made using algorithms or other automatic determination means. In some embodiments, the determination may be improved by machine learning techniques and/or artificial intelligence that have been trained on reference images (e.g. images captured previously be the image capturing sensor 104).

The determination may be made by a processor of the image capturing sensor 104, or the image capturing sensor 104 may be configured to transmit the images and/or the colour data associated with said images to the control unit 110, a user device 112 and/or the remote monitoring centre 113, which in turn may determine whether the colour data of the images is indicative of a potential fire.

In step 705, once the images start showing colours indicative of a potential fire, an alert signal may be generated and transmitted.

Returning to Fig. 6, and in particular step 603c, another example includes one or more temperature sensors 106 being put into a fire detection mode. In the fire detection mode, the temperature sensor 106 may be configured to continuously (and/or repeatedly) monitor a temperature inside the premises 120 so as to detect if and when the temperature increases or changes in a way consistent with or indicative of a potential fire having started within the premises 120.

For example, a temperature threshold may be set, or if a threshold already exists, the threshold may be lowered (i.e. to increase the sensitivity), such that an alert signal is triggered when the temperature exceeds the threshold. As another example, the system may identify a sudden increase in temperature (e.g. a predetermined temperature rise within a predetermined time period).

As yet another example, one or more a thermal radiation-based sensor 107 (e.g. a photosensor, an infrared sensor, a PIR sensor) may be put into a fire detection mode. Such a sensor 101 may be used to monitor an amount an incident infrared light (or other thermal radiation) and compare the amount of incident infrared light to a reference or threshold amount, in order to determine if the amount of incident infrared light has increased in a way indicative of a fire having started within the premises 120.

For example, a radiation threshold may be set, or if a threshold already exists, the threshold may be lowered (i.e. to increase the sensitivity), such that an alert signal is triggered when the radiation exceeds the threshold. As another example, the system may identify a sudden increase in incident radiation (e.g. a predetermined increase in incident radiation within a predetermined time period). As yet another example, the sensor 101 (e.g. a PIR sensor) may be configured to detect a stark thermal contrast between adjacent areas of its field of view.

The thermal radiation-based sensor 107 may accordingly detect a fire even if the line of sight is obstructed by certain materials (e.g. materials which may be opaque to visible light but transparent to infrared light).

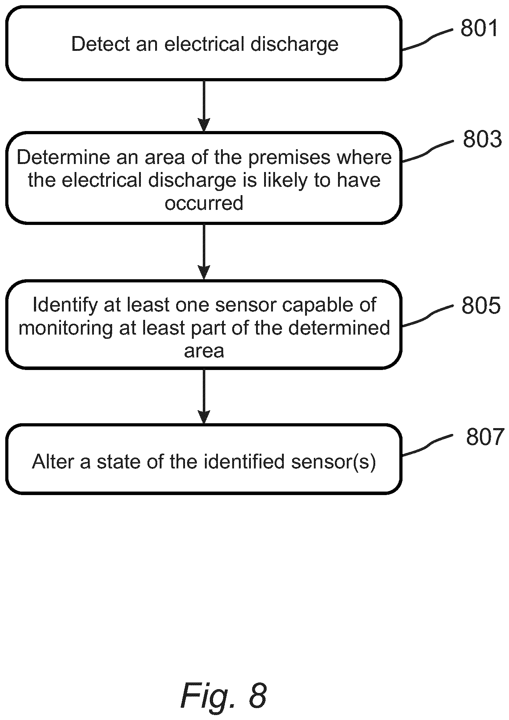

Fig. 8 shows a further method of operating the security monitoring system 100 where the system is configured to determine an area of the premises 120 within which the electrical discharge has likely occurred. The security monitoring system 100 used in the method of Fig. 8 comprises an additional electrical discharge detector 108 connected to another outlet 203 of the electrical wiring.

In step 801, at least one of the electrical discharge detectors 108 detects an electrical discharge which could be a precursor to a fire. The detection in step 801 is substantially equivalent to the detection in step 401 of Fig. 4, step 501 of Fig. 5 and step 601 of Fig. 6.

In step 803, the system is configured to determine a likely area of the premises 120 within which the electrical discharge occurred.

The area of the premises 120 in which the electrical discharge is likely to have occurred may be determined using time-of-arrival techniques for the transient signals identified by the electrical discharge detectors 108. In particular, a time difference between the arrival of a transient signal at a first electrical discharge detector 108 and the arrival of the same transient signal at a second electrical discharge detector 108 may be used to determine a relative distance for each of the electrical discharge detectors 108 to the location of the electrical discharge. In particular, the two electrical discharge detectors 108 can use the pulse shape to recognise the relevant transient signal caused by the electrical discharge (from the remaining signal), and accordingly calculate a time difference between the arrival of the (same) relevant transient signal for the two electrical discharge detectors 108.

The security monitoring system 100 may thereafter determine a likely area of the premises in dependence on where the two electrical discharge detectors 108 are located and the layout of the electrical wiring in the premises 120.

In step 805, the security monitoring system 100 identifies one or more of its sensors 101 that monitors or is located in at least part of the determined area.

In step 807, a state of the identified sensor(s) 101 is altered in accordance with step 603 of Fig. 6. Once the state has been altered, the sensor 101 may be configured to monitor at least part of the determined area so as to allow detection of a potential fire (and/or a precursor to a fire) in the premises 120, in accordance with step 605 of Fig. 6.

If the monitoring by the sensor 101 in the second state indicates that a potential fire may have started in the premises 120, an alert signal may be transmitted.

Fig. 9 shows another exemplary method of operating the security monitoring system 100 where the one or more actions performed in response to the electrical discharge detection includes determining if anyone is present within the premises 120.

In particular, when an electrical discharge has been detected, the security monitoring system 100 is configured to determine if anyone (e.g. a person such as an occupant or resident, and/or an animal such as a pet) is (physically) present within the premises 120, and to decide an action in dependence on whether anyone is present in the premises 120 or not.

In step 901, the electrical discharge detector 108 detects a likely electrical discharge which could be a precursor to a fire. The electrical discharge detector 108 may detect the electrical discharge according to the method of Fig. 3 or any other suitable method. The detection in step 901 is substantially equivalent to the detection in step 401 of Fig. 4 or step 501 of Fig. 5.

Once an electrical discharge has been detected, the electrical discharge detector 108 transmits a detection signal to the security monitoring system 100 (e.g. to the control unit 110) and/or the remote monitoring centre 113.

Importantly, and as previously mentioned, the electrical discharge detector 108 is configured to be active irrespective of whether the security monitoring system 100 is in an armed or disarmed state (i.e. the electrical discharge detector 108 is substantially always active) and can hence detect electrical discharges that occur at any time (e.g. even if someone is present in the premises 120 and the security monitoring system 100 is disarmed).

In step 903, the security monitoring system 100 determines if anyone is likely to be present in the premises 120. The determination in step 903 may be performed in response to receiving the detection signal from the electrical discharge detector 108 that an electrical discharge has been detected. Alternatively, the determination may have been made prior to the electrical discharge being detected, for example, not long before the electrical discharge was detected.

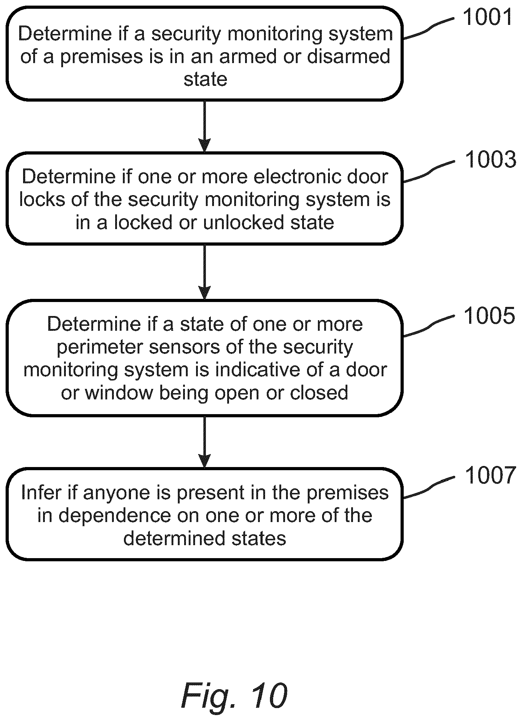

The security monitoring system 100 may determine whether someone is present in the premises 120 by (i) inferring that someone is likely to be present in the premises 120 from a security state of the security monitoring system 100, (ii) detecting the presence of someone in the premises 120 by one or more sensors 101, (iii) receiving input from one or more users about the presence of someone in the premises 120, or a combination thereof. These methods of determining if anyone is present in the premises 120 will be described in more detail in relation to Figs. 10 to 12.

After the determination has been made, the security monitoring system 100 selects an action in dependence on whether anyone is present in the premises 120 or not. In particular, the security monitoring system 100 may decide on a first action if it is determined that there is someone present in the premises 120, and on a second (e.g. different) action if it is determined that no-one is present in the premises 120. In other words, the security monitoring system 100 may select one of the first and second actions in dependence on the security monitoring system 100 having determined that anyone is present in the premises 120 or not. It will accordingly be appreciated that only one of the steps 905 and 907 may be performed.

In some embodiments, both of steps 905 and step 907 may be performed. For example, if it is determined that no one is present in the premises, the security monitoring system 100 may first select and perform the second action (i.e. step 907). The system may then be configured to wait for a predetermined time, such as one or more hours, after which it repeats the presence determination in step 903. If, upon the repeated presence determination, it is now determined that someone is present in the premises, the system may select and perform the first action (i.e. step 905). On the contrary, if no one is still not present in the premises, the security monitoring system 100 may be configured to again select and perform the second action. The system may also be configured to repeat this sequence of steps one or more times, for example until an occupant returns to the premises and/or the cause of the electrical discharge is resolved.

If the security monitoring system 100 has determined that there is someone present in the premises 120, the security monitoring system 100 performs, in step 905, the first action. To reduce the risk of a catastrophic fire, the first action may include transmitting an action signal to one or more alarm indicators 109 (such as a siren within the premises 120) instructing the alarm indicator(s) 109 to set off an alarm. Hence, people present in the premises 120 are alerted and can evacuate the premises 120. Additionally, the first action may include transmitting an action signal to the emergency services (e.g. the fire brigade) notifying them that a potential fire may break out. Hence, any fire caused by the electrical discharge can hopefully be put out at an early stage.

If, instead, the security monitoring system 100 has determined that no one is present in the premises 120, the security monitoring system 100 performs, in step 907, the second action. Because it has been determined that no one is, and/or is likely to be, present in the premises 120, no one is in immediate danger and the second action may accordingly be different to the first action. However, if there is uncertainty as to whether anyone is present in the premises 120, the second action may also include starting one or more alarm indicators 109 such as a siren and/or notifying the emergency services.

In particular, the second action may include transmitting an action signal for (i) altering a sensor state of one or more sensors 101 of the security monitoring system 100 according to any of the methods described in relation to Figs. 6 to 8, (ii) monitoring the premises 120 (e.g. by one or more activated sensors 101 and/or by an operator at the remote monitoring centre 113 viewing sensor data such as images sent by an image capturing sensor 104), (iii) sending a notification (e.g. a push notification) to a user device 112, (iv) contacting (e.g. calling, for example by an operator at the remote monitoring centre 113) an occupant or resident of the premises 120, (v) notifying and/or contacting a designated person (such as a neighbour or relative), or a combination thereof.

The method may further comprise an optional step 909 where the system, after the second action has been performed in step 907, determines if the second action has been successful, e.g. has been successful in notifying and/or contacting a user and/or operator. For example, the system may, in step 909, determine if a user (e.g. an occupant, resident, and/or designated person) has been notified by the second action. For instance, the system may determine if the user has answered the call from the remote monitoring centre 113, and/or if the user has opened the push notification sent to the user device 112 (e.g. a read receipt may be sent from the user device 112 once the user opens the push notification and/or the app). As another example, the system may, in step 909, determine if an operator at the remote monitoring centre 113 has opened or interacted with sensor data from one or more activated sensors 101.

If the system determines that the second action has not been successful (e.g. if a user has not answered the call and/or opened the push notification within a predetermined time), the system may, in step 911, repeat step 907 (e.g. by calling the user again and/or calling a different telephone number associated with the same or another user) and/or take another action such as starting an alarm indicator 109 in the premises 120 and/or notifying the emergency services.

The method of Fig. 9 thus allows the security monitoring system 100 to adjust a level of urgency in its response to a detected electrical discharge in dependence on whether anyone is present in the premises 120 or not.

Fig. 10 is a method of determining if someone is present in the premises 120. Accordingly, the determination in step 903 of Fig. 9 may comprise one or more of steps 1001 to 1007.

In the method of Fig. 10, the security monitoring system 100 is configured to infer whether anyone is present in the premises 120 from one or more security states of the security monitoring system 100. In particular, the security states may comprise an armed or disarmed state of the security monitoring system 100, a locked or unlocked state of one or more electronic door locks 114, and/or a state of one or more perimeter sensors 103 indicating that a corresponding door 121 or window 122 is opened or closed.

Thus, if the security state indicates that the premises 120 is not protected or secured (e.g. if a window 122 or door 121 is open, if the security monitoring system 100 is disarmed, and/or if an electronic door lock 114 is unlocked), the security monitoring system 100 may infer that someone is present inside the premises 120. It is noted that the control unit 110 may be configured to store the present security state(s) of the security monitoring system 100 such that the security monitoring system 100 can request and/or obtain information about current security state(s).

In step 1001, the security monitoring system 100 determines if the system is in an armed, disarmed state, or partially armed state (e.g. a perimeter is armed but not an interior of the premises 120, and/or only a part of the interior being armed). The security monitoring system 100 may then infer if anyone is present in the premises 120 or not in dependence on the determined state.

If the security monitoring system 100 is disarmed, it may be inferred or assumed that someone is likely to be present in the premises 120 (noting that it is safer to incorrectly assume someone is present in the premises 120 than to incorrectly assume no one is present in the premises 120). Similarly, if the security monitoring system 100 is armed (e.g. both perimeter sensors 103 and interior sensors such as presence sensors 102 being in an armed state), it may be inferred that no one is present in the premises 120. If the security monitoring system 100, however, is in a partially armed state (e.g. if perimeter sensors 103 are armed but interior sensors such as presence sensors 102 are disarmed), it may only be assumed or inferred that someone is present in the premises 120 or that the determination in step 501 is inconclusive. For example, it is common for the security monitoring system 100 to be in a partially armed state when people in the premises 120 are sleeping such that they are alerted to any intruders breaking through the perimeter but may still move within the premises 120 without triggering the alarm.

In some embodiments, step 1001 comprises determining whether interior sensors (e.g. presence sensors 102, thermal sensors, motion sensors) of the security monitoring system 100 are in an armed or disarmed state.

In step 1003, the security monitoring system 100 determines if one or more electronic door locks 114 are in a locked or unlocked state, i.e. if the door 121 fitted with the electronic door lock 114 is locked or unlocked. The security monitoring system 100 may then infer if anyone is present in the premises 120 or not in dependence on the determined state. In particular, it may be inferred from an electronic door lock 114 in an unlocked state, that someone is likely to be present in the premises 120. It is noted, however, that no useful conclusion can be inferred if the electronic door lock 114 is locked, because a user may lock their door 121 even if they are at home and present in the premises 120.

In step 1005, the security monitoring system 100 determines if a state of one or more perimeter sensors 103 indicates that a corresponding door 121 or window 122 is open or closed. For example, the security monitoring system 100 can determine whether a perimeter sensor 103 in the form of a magnetic sensor registers magnetic contact thus indicating that the door 121 or window 122 is closed, or the opposite.

The security monitoring system 100 may then infer if anyone is present in the premises 120 or not in dependence on the determined state. In particular, the security monitoring system 100 may infer that someone is present in the premises 120 if the perimeter sensor state indicates that the door 121 or window 122 is open. It is again noted, however, that no useful conclusion can be inferred if the perimeter sensor 103 indicates that a door 121 or window 122 is closed, because a user may close their door(s) 121 and/or window(s) 122 even if they are at home and present in the premises 120.

In step 1007, the security monitoring system 100 determines whether anyone is likely to be present in the premises 120 based on the inferred information from one or more of steps 1001 to 1005. For example, the security monitoring system 100 may determine that someone is present in the premises 120 if it has been inferred that someone is present in the premises 120 in at least one of steps 1001 to 1005.

Alternatively, or additionally, the security monitoring system 100 may assume that someone is present in the premises 120 if none of the steps 1001 to 1005 conclusively infers that no one is present in the premises 120.

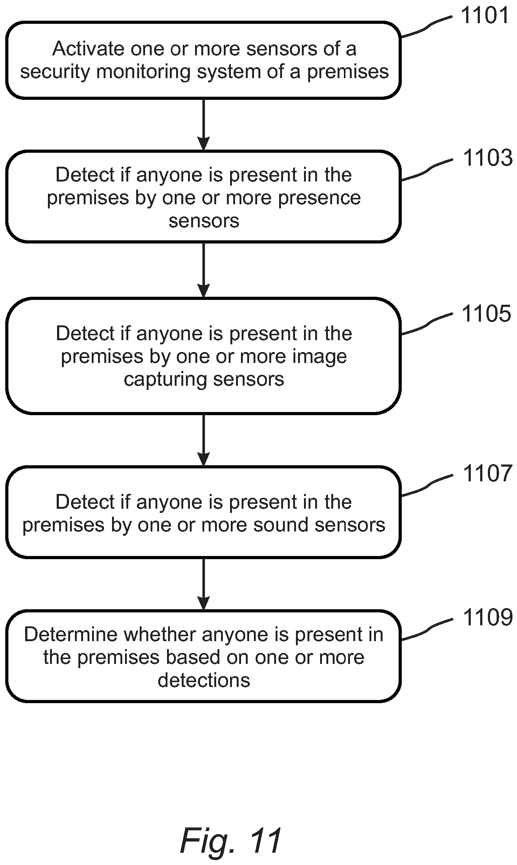

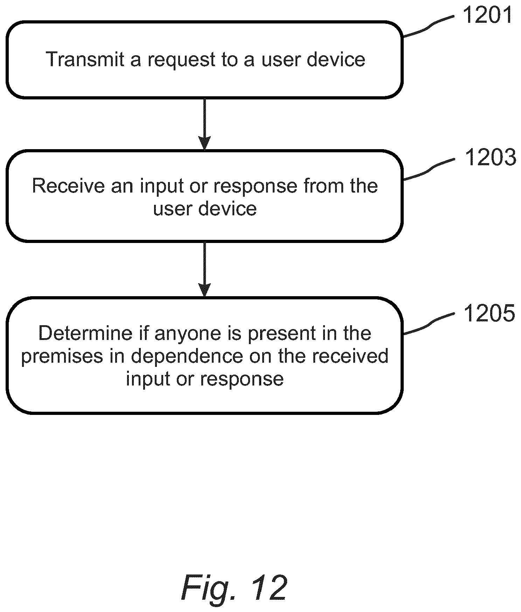

Alternatively, the security monitoring system 100 may, if none of the steps 1001 to 1005 provide a useful conclusion (e.g. if none of the steps infer that anyone is present and/or none of the steps infer that no one is present), perform another method (e.g. the one or more of the methods of Fig. 11 and 12) to determine if someone is present in the premises 120.

Yet as another alternative, if the security monitoring system 100 may assume that someone is present in the premises 120, if the system based on steps 1001 to 1005 is uncertain, or if the information received in steps 1001 to 1005 is inconclusive. Again, it is noted that it is safer to incorrectly assume someone is present in the premises 120 than to incorrectly assume no one is present in the premises 120.

It is noted that the method of Fig. 10 may comprise only one of steps 1001 to 1005, or a combination of at least some of the steps 1001 to 1005. In some embodiments, the security monitoring system 100 is configured to perform at least two, and preferably all, of steps 1001 to 1005.

Fig. 11 is another method of determining if anyone is present in the premises 120. Accordingly, the determination in step 903 of Fig. 9 may comprise one or more of steps 1101 to 1109. It will be appreciated that the method of Fig. 11 may be performed separately from, or in combination with, the method of Fig. 10.

In the method of Fig. 11, the security monitoring system 100 is configured to detect if anyone is present in the premises 120 using one or more sensors 101 of the security monitoring system 100.

In step 1101, the security monitoring system 100 activates one or more sensors 101 suitable for detecting presence of anyone in the premises 120. In particular, one or more presence sensors 102, one or more image capturing sensors 104 and/or one or more sound sensors 115 (such as microphones) may be activated. The security monitoring system 100 may accordingly, by activating the sensor(s) 101, detect presence even if the system 100 is in a disarmed state in which the sensors 101 are not normally active.

Of course, it will be appreciated that if the sensor(s) 101 are already activated, e.g. if the security monitoring system 100 is in an armed state, step 601 may be omitted.

In step 1103, one or more (activated) presence sensors 102 (e.g. one or more thermal sensors, one or more thermal radiation-based sensors 107, one or more infrared sensors, one or more PIR sensors, one or more image capturing sensors 104, and/or one or more motion sensors) monitor an area of the premises 120 to detect if anyone is present in the premises 120. The detection may be made using any known presence sensor according to any known method of detecting presence by such a presence sensor. In particular, the presence detection may be performed using an infrared sensor, such as a PIR sensor, in dependence on an incident amount of infrared light.

In step 1105, which may be performed in addition to (e.g. simultaneously with, before and/or after) step 1103, or as an alternative to step 1103, one or more images from an image capturing sensor 104 are monitored to detect if anyone is present in the premises 120.

The one or more images may be (still and/or moving) images previously captured by the image capturing sensor 104 and/or new (still and/or moving) images taken in response to a request from the security monitoring system 100. The images may be monitored by an operator at the remote monitoring centre 113, and/or may be analysed by an image analyser configured to detect human or animal-like objects.

In some embodiments, information relating to the presence of anyone in the premises 120 may be inferred from the images even if the images do not directly show a person or animal. As an example, the presence may be inferred from a lighting amount in the images. For instance, the security monitoring system may infer presence if the lighting amount is inconsistent with a typical (or reference) lighting amount associated with the time of day. As an example, if the images are light (e.g. lighter than a reference image) and it can be determined that a time of day corresponds to nighttime, it may be inferred that a lamp or other lighting device is turned on within the premises 120 meaning that someone is likely to be present in the premises 120.

In step 1107, which may be performed in addition to step 1103 and/or 1105, or as an alternative to step 1103 and/or 1105, a sound sensor 115 monitors sounds in the premises 120. The sound sensor 115 can accordingly detect presence of someone in the premises 120 (or at least infer presence of someone in the premises 120) if sound is detected.

It is noted that the method of Fig. 11 may comprise only one of steps 1103, 1105 and 1107, or a combination of steps 1103, 1105 and/or 1107.

In step 1109, the security monitoring system 100 determines whether anyone is likely to be present in the premises 120 based on detections in one or more of steps 1103 to 1107. For example, it may be determined that someone is present in the premises 120 if at least one of steps 1103 to 1107 detects presence. If the security monitoring system 100 cannot determine whether anyone is present in the premises 120, and/or if the detection in steps 1103 to 1107 is inconclusive, the security monitoring system 100 may perform another method (e.g. the one or more of the methods of Fig. 10 and 12) to determine if someone is present in the premises 120.

Alternatively, or additionally, to the method of Fig. 11, presence may be detected by the radio-based sensing arrangement 130 as will be described later in relation to Figs. 13 to 14.

Fig. 12 is yet another method of determining if someone is present in the premises 120. Accordingly, the determination in step 903 of Fig. 9 may comprise one or more of steps 1201 to 1205. It will be appreciated that the method of Fig. 12 may be performed separately from, or in combination with, the methods of Figs. 10 and/or 11.

In the method of Fig. 12, the security monitoring system 100 is configured to request a user (e.g. an occupant or resident of the premises 120) to confirm if anyone is present in the premises 120. In particular, the method of Fig. 12 comprises one or more of the following steps.

In step 1201, the security monitoring system 100 transmits a request to one or more user devices 112 associated with an occupant or resident of the premises 120. In particular, the request may be in the form of a push notification to the security system app installed on the user device 112. The push notification and/or the app may allow the user to input confirmation of whether the user and/or any other person or animal is present in the premises 120. Alternatively, the request may take the form of a phone call from the remote monitoring centre 113 to a phone number associated with an occupant or resident of the premises 120.

In step 1203, the security monitoring system 100 receives an input or response from the user in response to the transmitted request. The input or response may comprise a confirmation from the user whether anyone is present in the premises 120 or not. The input or response from the user may additionally or alternatively inform the security monitoring system 100 that a second request should be transmitted to an additional user (e.g. if another user is better placed to know whether anyone is present in the premises 120).

In step 1205, the security monitoring system 100 determines whether anyone is present in the premises 120 in dependence on the input or response received from the user.

If the user does not respond to the request within a predetermined time period, the security management system 100 may assume that someone is present in the premises 120 and/or perform another method (e.g. the one or more of the methods of Fig. 10 and 11) to determine if someone is present in the premises 120.

In some embodiments, the presence determination may alternatively, or additionally, be performed in dependence on a time and/or date (e.g. which weekday it is) and typical habits or patterns of the occupant(s) of the premises 120. In particular, the security monitoring system 100 may be configured to determine or retrieve a time of day and infer presence in dependence on the time and/or date and typical habits of one or more occupants of the premises 120. The determination of the time and/or date may include receiving the time and/or date from a device (e.g. a device of the security monitoring system 100), such as a control unit 110, one or more sensors 101 or any other device programmed with the time and/or date.

Furthermore, the security monitoring system 100 may know one or more habits or patterns of occupant(s) (e.g. that the occupant(s) always leaves the premises 120 at certain times). This may be known (i) from typical patterns of when the user arms/disarms the security monitoring system 100, (ii) from typical patterns of when a sensor 101 (e.g. a doorbell camera and/or a perimeter sensor 103) notices that the occupant leaves/enters the premises 120, (iii) from typical patterns of when the radio-based sensing arrangement 130 notices when an occupant is present in one or more zones of the premises 140, or the like. Hence, if the system knows that an occupant is always away from the premises 120 at certain times (say, for a couple of hours in the evening), it can infer that the no one is present at the premises 120 during that time of day. Similarly, if the system knows that an occupant is typically present at the premises 120 at certain times, it can infer that someone is likely to be present in the premises 120 at that time of day.

As already mentioned, the previously described presence determination methods (including the methods of Figs. 10 to 12) may be performed separately or in combination. For example, the security monitoring system 100 may initially be configured to perform one of the methods (e.g. one of the methods in Figs. 10 to 12) of determining if anyone is present in the premises 120, and, if necessary, one or more of the remaining methods may be subsequently performed. Alternatively, the security monitoring system 100 may be configured to perform two or more of the presence determination methods simultaneously to increase the speed of determination. By combining two or more of the methods of determining if anyone is present in the premises 120, an accuracy of said determination is improved. It will also be appreciated that the methods described are purely exemplary, and the determination of whether anyone is present in the premises 120 or not may be performed by any suitable method.

Fig. 13 shows the radio-based sensing arrangement 130 which may be arranged in the premises 120 alongside the security monitoring system 100. Note that, for simplicity, only selected devices (i.e. the control unit 110, the electrical discharge detector 108, and the image-capturing sensor 104) of the security monitoring system 100 are shown in Fig. 13.

Although described in relation to a security monitoring system 100, it will be appreciated that the radio-based sensing arrangement 130 may also be provided separately from such a security monitoring system 100. For instance, the radio-based sensing arrangement 130 may be arranged in a premises 103 without a security monitoring system 100. In such a case, the radio-based sensing arrangement 130 may comprise the electrical discharge detector 108.

The radio-based sensing arrangement 130 may be part of or communicatively connected to the security monitoring system 100 such that data, information, and/or signals can be communicated and transmitted between the radio-based sensing arrangement 130 and the security monitoring system 100.

The radio-based sensing arrangement 130 is configured to detect human presence throughout the premises 120. Accordingly, the radio-based sensing arrangement 130 may also be referred to as a radio-based presence sensing arrangement. In particular, the radio-based sensing arrangement 130 is configured to sense presence by detecting perturbations of radio signals received by one or more nodes 131 of the radio-based sensing arrangement 130.

A radio signal as used herein refers to a signal transmitted from a radio transmitter and received by a radio receiver, wherein the radio transmitter and radio receiver operate according to a standard or protocol. Such standards include, but are not limited to, IEEE 802.11. (which includes the Wi-Fi standards), IEEE 802.15 (which includes Zigbee), Bluetooth SIG, IEEE 802.16, IEEE 802.20, UMTS, GSM 850, GSM 900, GSM 180, GSM 19011, GPM ITU-R 5.13, GPM IT U-R 5.150, ITU-R 5.280, 3GPP 4G (including LTE), 3GPP 5G, 3GPP NR, AND IMT-2000. However, the radio transmitters and receivers may also operate in non-telecommunications or Industrial, Scientific and Medical (ISM) spectral regions without departing from the scope of embodiments.

The radio-based sensing arrangement 130 may, in addition to detecting presence, be configured to detect location (e.g. of humans) in dependence on the detected perturbations of the radio signals. For example, the radio-based sensing arrangement 130 may be configured to recognise different location "zones" which may map to rooms, floors, regions within rooms, and/or exterior regions of the premises 120 such as a terrace, front garden, parking area, or the like.

The radio-based sensing arrangement 130 may further be configured to perform people counting. For example, the techniques and methods described in US2020/0302187A1, which is incorporated herein by reference in its entirety, can be used to count occupants and determine their locations in arrangements, systems and methods according to embodiments of the invention.

The radio-based sensing arrangement 130 comprises one or more nodes 131 distributed throughout the premises 120.

At least one of the nodes 131 is capable of receiving radio signals, and may therefore be referred to as a receiver node 131a. Although only one receiver node 131a is shown in Fig. 13, it will be appreciated that the arrangement may comprise any number of receiver nodes 131a. The receiver node 131a may in addition to receiving the radio signals be configured to process the received radio signals to detect any perturbations, e.g. relative to a reference signal. Alternatively, the processing may be performed by a separate processing unit which may be located within the premises 120 and/or remotely. Furthermore, the receiver node(s) 131a may be configured to function as an access point of the radio network whose signals are used by the radio-based sensing arrangement 130.

The remaining nodes 131 may each comprise a radio transmitter such that they can transmit radio signals, for instance to the receiver node 131a. Accordingly, the transmitting nodes 131 may illuminate the receiver node 131a with their signals since the transmissions enable collection of information about the channel (or in other words, illuminates the channel). Such nodes 131 may accordingly be referred to as illuminator nodes 131b. It will be noted that there are typically a plurality of illuminator nodes 131b for each receiver node 131a, and that a single receiver node 131a may be sufficient to perform radio-based sensing of the premises 120.

Of course, at least some of the nodes may comprise a radio transceiver allowing them to both transmit and receive radio signals, i.e. to function as both an illuminator node 131b and a receiver node 131a. Similarly, a single device may comprise both an illuminator node 131b and a receiver node 131a.

To ensure that the radio-based sensing arrangement 130 effectively covers the whole area of interest (for example, one or more floors or regions of the premises 120), the radio-based sensing arrangement 130 comprises a sufficient number of suitably located and distributed illuminator nodes 131b so that the radio signals received by the receiver node 131a have effectively traversed the whole area of interest.

If the radio-based sensing arrangement 130 is to cover a plurality of floors, the sensing arrangement 130 may comprise one receiver node 131a on each floor, together with an appropriate number of suitably positioned illuminator nodes 131b. However, depending on the construction of the premises 120, signals from one or more illuminator nodes 131b on one floor may be used by a receiver node 131a on another floor.

Because radio transmitters and/or transceivers have a relatively high power consumption, the nodes 131 are advantageously mains powered (optionally with a backup power supply in the form of a battery or the like) rather than solely battery powered. Accordingly, each of the nodes 131 (or at least some of the nodes 131) may be formed by a radio-capable device that is normally plugged into the mains.

The inventors have therefore realised that it is particularly suitable to use the electrical discharge detector 108 of the security monitoring system 100 as one of the nodes 131 in the radio-based sensing arrangement 130 because the electrical discharge detector 108 is, in normal operation, always connected to the mains (i.e. the electrical wiring) of the premises 120.

The electrical discharge detector 108 may form any node 131 of the radio-based sensing arrangement 130. For example, an electrical discharge detector 108 comprising a radio transmitter may be used as an illuminator node 131b in the radio-based sensing arrangement 130, while an electrical discharge detector 108 comprising a radio transceiver may be used as an illuminator node 131b and/or a receiver node 131a in the radio-based sensing arrangement 130. Although reference is made to a single electrical discharge detector 108, it will be appreciated that a plurality of electrical discharge detectors 108 may form a respective plurality of nodes 131 of the radio-based sensing arrangement 130.

The radio-based sensing arrangement 130 according to embodiments may be based on Wi-Fi signals. The radio-based sensing arrangement 130 may then be referred to as a Wi-Fi sensing arrangement. However, although reference will occasionally be made to such a Wi-Fi sensing arrangement, it will be appreciated that the illustrative examples and embodiments described herein may equally be applied to and/or include other sensing arrangements based on any type of radio signals using any radio communications standard or protocol.

A sensing arrangement 130 based on Wi-Fi signals is particularly convenient because it can utilise Wi-Fi networks that are commonly already used and available in premises 120 such as households or residential buildings. Furthermore, Wi-Fi capable devices, which are also commonly available in premises 120, can function as nodes (and in particular as illuminator nodes 131b) in the Wi-Fi sensing arrangement. Examples of such Wi-Fi capable devices include devices of a smart-home system 150 (as will be described in relation to Figs. 15 to 17) such as a smart-home controller, smart devices, smart plugs, smart wall switches, smart luminary devices, smart home appliances, smart home entertainment devices, smart security monitoring sensors, or the like. Other examples of such Wi-Fi capable devices include Wi-Fi access points, Wi-Fi routers, Wi-Fi range extenders (for example of the type that simply plug in to a socket of the mains electricity supply), smart doorbells, Wi-Fi enabled video cameras, or the like.

The Wi-Fi sensing arrangement may be based on any type of Wi-Fi network and/or topology, operating in different frequency bands (such as 2.4, 5, 6, and 60 GHz) and different bandwidths.

The Wi-Fi sensing may be performed with any Wi-Fi capable device and can be used on any available communication path. Each communication path between two Wi-Fi capable devices gives the chance to extract information about the surrounding environment. Because Wi-Fi networks typically have many devices connected to them and spread throughout the premises 120, they are well suited to exploiting these devices' transmissions to provide accurate sensing.

Depending on the number of devices, the Wi-Fi sensing arrangement may be monostatic, bistatic, or multi-static. In monostatic Wi-Fi sensing, a single device measures its own transmitted Wi-Fi signals (i.e. acts as both illuminator node 131b and receiver node 131a). In bistatic Wi-Fi sensing, the receiver node 131a and illuminator node 131b are formed by two different devices. In multi-static Wi-Fi sensing, the received signals from multiple illuminator nodes 131b are used to learn about a shared environment.

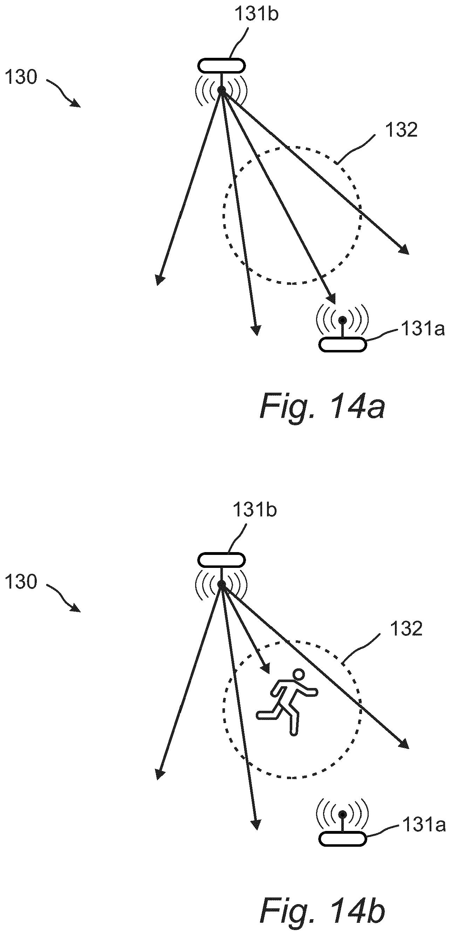

At least one illuminator node 131b and one receiver node 131a are required to perform sensing measurements, and these can be located in the same device (to create a kind of monostatic radar) or in different devices. In particular, the sensing is performed by a receiver node 131a on signal(s) transmitted by one or more illuminator nodes 131b and will be described further now in relation to Figs. 14a and 14b.

Figs. 14a and 14b show a very schematic illustration of the idea behind radio-based sensing using a radio-based sensing arrangement 130, such as a Wi-Fi sensing arrangement. In Figs. 14a and 14b, a single illuminator node 131b and a single receiver node 131a are illustrated for simplicity, although in practice there will typically be a plurality of illuminator nodes 131b and sometimes a plurality of receiver nodes 131a. The radio-based sensing arrangement 130 of Figs. 14a and 14b is installed to monitor an area 132 of the premises 120.

Fig. 14a shows the radio-based sensing arrangement 130 in a default or reference state in which no person is present in the monitored area 132. In the absence of human presence, radio signals are transmitted from the illuminator node 131b, spread through the monitored area 132, and are received by the receiver node 131a.

Of course, in most installations there will be walls, ceilings, floors, and other structures that will tend to reflect, at least in part, signals transmitted from the illuminator node 131b. Furniture and other objects may block or attenuate the signals, the reflected signals will give rise to multiple paths, the signals may interfere with each other, and there may be scattering and other behaviours, such as phase shifts, frequency shifts, all leading to complexity in the channels experienced by the radio signals that arrive at the receiver node. But while the environment is static and unchanging, the receiver will tend to see a consistent pattern of radio signals. This is true whether or not the source transmits continuously or transmits periodically. However, this consistent pattern of received signals is changed by the arrival of a person, as shown in Figure 14b.

From Figure 14b it can be seen that the presence of a person in the monitored area 132 blocks at least some of the signals from the illuminator node 131b, and that affects the pattern of radio signals received by the receiver node 131a. The changed pattern of signals received by the receiver node 131a enables the presence of the person to be detected by a presence monitoring algorithm that is supplied with information derived from the received signals. It will be appreciated that the nature and extent of the perturbation of the signals passing from the illuminator node 131b to the receiver node 131a is likely to change as the person enters, passes through, and leaves the monitored area 132, and that this applies also to reflected, refracted, and attenuated signals. These changes may enable the location of a person within the monitored area 132, and their speed of movement, to be determined Indeed, these techniques have been shown even to be capable of detecting gestures, and patterns of human respiration, as well as enabling "people counting".

It will be realised that signals that are received from an illuminator node 131b (or from more than one illuminator node 131b) after having passed through the monitored space 132 have in effect been filtered by the environment to which they have been exposed. The monitored area 132 or space can therefore be seen as a filter having a transfer coefficient, and the received signal is at least in part defined by the properties, or channel response, of the wireless channel through which it propagated. If the environment provided by the monitored area changes, for example by the addition of a person, then the transfer coefficient of the filter, and the channel response or properties, will also change. The changes in the transfer coefficient, and in the channel response, consequent on the change in the environment of the monitored space, can be detected and quantified by analysing radio signals received by the receiver node 131a. Both the introduction of an object, e.g. a person, into the monitored space 132, and movement of that object within the monitored space 132 will change the environment and hence change the effective transfer coefficient and the channel response.

Accordingly, the presence detection by the radio-based sensing arrangement 130 may be based on analysing the signal dynamics and/or signal statistics of received radio signals and/or detecting changes in channel state information.

Essentially, radio signals are used to probe a zone or zones of interest, and to analyse and extract statistics from these signals. When Wi-Fi signals are used, i.e. when the radio-based sensing arrangement is a Wi-Fi sensing arrangement, a physical layer and/or data link layer such as MAC address measurements that expose the frequency response of a radio channel (e.g., CSI or RSSI measurements) may be measured and analysed.

These measurements or statistics are then processed to detect anomalies and variations (i.e. perturbations) over time, and in particular to detect changes signifying the entrance of a person and/or movement of a person within a monitored area 132.

Because presence is detected by detecting a change in the properties or character of radio signals compared to some previous reference signal(s), it is preferred to use illuminator nodes 131b that remain in the same position for extended periods rather than relying on devices that are repeatedly moved, such as smart phones, headphones, laptops, and tablet devices.

Again, as the electrical discharge detector 108 is intended to always be connected to the same electrical outlet 203 (so as to detect electrical discharges and potential fire precursors when they occur), the electrical discharge detector 108 is particularly suitable to function as one of the nodes in the radio-based sensing arrangement.

It is not strictly speaking essential for all the devices whose signals are used by the radio-based sensing arrangement to be part of the same network. For example, signals from Wi-Fi access points of neighbouring premises could be used as part of a sensing arrangement in a different premises. Again, a primary consideration is the stability of the signals from the signal sources that are used.

Further, the radio-based sensing arrangement can be trained to recognise specific perturbations corresponding to human presence. For example, the radio-based sensing arrangement may be trained by establishing a base or reference setting in which the monitored area 132 is unoccupied, and then training occupied states by a person entering, standing, and then walking through each of the zones one by one. This process may be repeated with two people, and then optionally with more people. In essence this is a supervised machine learning approach, but other approaches to training may be used. The system may need to be retrained setting if bulky furniture or other large objects (particularly if made of metal) are added to or moved within the monitored space, because these can be expected to change the propagation properties of the relevant zone/space.

Although the example in Figs. 14a and 14b uses just a single illuminator node 131b and a single receiver node 131a, as already mentioned generally multiple illuminator nodes 131b will be used in order to achieve satisfactory coverage of the zone or zones to be monitored. Multiple zones may be monitored by a single receiver node 131a through the use of multiple strategically placed illuminator nodes 131b, but each zone, or some zones of multiples zones may have a dedicated receiver node 131a that does not serve other zones. Likewise, an illuminator node 131b may provide illuminating signals for a single monitored zone or for multiple monitored zones. Also, the radio-based sensing arrangement may use a mesh network arrangement, for example a Wi-Fi mesh network, in which multiple devices act as receiver nodes 131a, either for a single monitored zone or for multiple monitored zones.

Further explanation of a radio-based sensing arrangement, and in particular a Wi-Fi sensing arrangement, according to embodiments is described in WO2023/126426A1 which is incorporated herein by reference in its entirety.

In some embodiments, one or more of the sensors 101 comprises a radio transmitter allowing the one or more sensors 101 to function as respective one or more illuminator nodes 131b in the radio-based sensing arrangement. For instance, the one or more sensors 101 may be provided with a Wi-Fi transmitter such that they can form nodes of a Wi-Fi sensing arrangement. As an example, an image capturing sensor 104 is often already provided with a Wi-Fi transmitter which is used to transmit images from the image capturing sensor 104 to the remote monitoring centre 113 and/or one or more user devices 112. Hence, the image capturing sensor 104 can, without major modification, be used for a second purpose as an illuminator node 131b of the Wi-Fi sensing arrangement.

The control unit 110 may also comprise a radio transceiver such that it can function as a receiver node 131a and/or illuminator node 131b of the radio-based sensing arrangement. The control unit 110 may also be configured to operate as an access point of the Wi-Fi network on which the Wi-Fi sensing arrangement is based making it particularly suitable as a node in the radio-based sensing arrangement. For example, the control unit 110 may, in addition to controlling the security monitoring system 100, also control the radio-based sensing arrangement 130.

It will be understood that the radio-based sensing arrangement 130 may be used to complement and/or improve presence detection of the security monitoring system 100 which has conventionally only been performed by sensors 101 of the security monitoring system 100. As such, the radio-based sensing arrangement 130 may be configured to notify a control unit 110 of the security monitoring system 100 whenever presence is detected (at least if the security monitoring system 100 is in an armed state).

Furthermore, the radio-based sensing arrangement 130 can be used to verify if an alert triggered by another sensor 101 of the security monitoring system 100 corresponds to a "true" alarm incurring event or is a "false alarm". For example, if another sensor 101 is triggered by what could potentially be an intruder, the security monitoring system 100 may be configured to verify if an intruder is present in the premises 120 using the radio-based sensing arrangement 130. In particular, a control unit 110 acting as the receiving node 131a may instruct one or more of the illuminator nodes 131b to transmit a radio signal on which the verification may be made.

Fig. 15 shows a smart home system 150 which may be installed alongside the security monitoring system 100 in the premises 120. The security monitoring system 100 is, however, for convenience not shown in Fig. 15.

In this context, "smart home system" should be understood as a system of connected (e.g. network-connected and/or internet-connected) devices in a premises together with a hub or other controller connected to the plurality of devices and being configured to control the plurality of devices. Hence, the smart-home system 150 may enable remote control, monitoring and/or management of the connected devices.

Although the term "smart-home system" is used throughout the present disclosure, it will be appreciated that this term is not limited to residential "homes" but includes any type of premises 120 such as single family or multi-unit residences, out-buildings, businesses, stores, factories, warehouses, restaurants, entertainment venues, and so forth. Also, the term "smart-home system" should be understood to mean any system formed by smart devices that communicate with a hub or controller and/or one another.

In this context, "smart devices" or "smart-home devices" may be defined as interconnected and/or network-connected devices that may be controlled remotely, e.g. via a smart-home controller (such as a hub).

In this context, "smart-home controller" should be understood to mean any device or unit configured to remotely control one or more smart devices, for example, over a network to which the smart-home controller and the smart devices are connected.

The smart home system 150 comprises a smart-home controller 151 (e.g. a smart-home hub) and one or more of smart devices 152.

The smart-home controller 151 is configured to control the smart devices 152 of the smart-home system 150. This smart-home controller 151 may be in the form of a hub, which is often a hardware device located in the premises 120, that acts as a central point of the smart-home system 150 and can process data and communicate wirelessly. However, the smart-home controller 151 may also be a remotely located controller, for example in the form of a central server, cloud-computing system or any other device (such as a smartphone or the like) that is network-connected anywhere in the world.

The smart-home controller 151 may be configured to communicate with the security monitoring system 100, the control unit 110 and/or be part of the control unit 110 of the security monitoring system 100. In some embodiments, the control unit 110 of the security monitoring system 100 may act as the smart-home controller 151.

In such configurations, the security monitoring system 100 and/or the control unit 110 may be configured to transmit instructions to the smart devices 152, e.g. either directly (by the control unit 110 acting as the smart-home controller 151) or indirectly via the separate smart-home controller 151 (the smart-home controller 151 effectively acting as a gateway between the smart devices 152 and the security monitoring system 100). The instructions may relate to the control of the smart devices 152, such as instructions relating to the control of one or more settings of the relevant smart device(s) 152.

The one or more smart devices 152 may include any devices that are connected to the network on which the smart-home system 150 is configured to operate, and which can be controlled remotely, e.g. by the smart-home controller 151. In particular, the smart devices 152 may be mains-powered such that they are connected to electrical wiring of the premises 120.

For example, the one or more smart devices 152 may include one or more smart plugs 153 (which may also be referred to as smart electrical outlets and/or smart electrical sockets), one or more smart wall switches 154, one or more smart luminary devices 155, one or more smart home appliances 156, one or more smart home entertainment devices 157, one or more smart security monitoring sensors 158, or any combination thereof.

A smart plug 153 may be defined as any type of network-connected plug, socket or other electrical outlet to which a device (such as a non-communicating legacy device) may be connected (by electrically connecting the device to the smart plug 153). The smart plug 153 can be installed in any existing electrical socket or outlet to enable remote control, over the network, of the electrical power supply from the electrical socket or outlet to the device connected to the smart plug 153. In particular, the smart-home controller 151 may remotely turn on or off the smart plug 153 so as to control the supply of power to the device connected to the smart plug 153.

A smart wall switch 154 may be defined as a network-connected wall switch that may be installed in place of an ordinary wall switch to allow the switch to be controlled over the network, e.g. by the smart-home controller 151, rather than only by physical touch as is required by an ordinary wall switch. The smart wall switch 154 may accordingly be used to control a luminary device, a blind, or any other device connected to the smart wall switch 154. The smart wall switch 154 may act as a simple switch (i.e. binary on/off) or as an adjustable dimmer or the like.

A smart luminary device 405 may be defined as a network-connected luminary device (which may also be referred to as a light-emitting device) that may be controlled remotely, e.g. by the smart-home controller 151. The smart luminary device 155 may be configured to emit visible light so as to light up its surroundings. Examples of smart luminary devices 155 include smart lightbulbs, smart lamps, smart LEDs, or the like. The term "smart luminary device" may also include non-communicating legacy luminary devices controlled by a smart wall switch 154 and/or a smart plug 153 because such luminary devices may also be remotely controlled (via the smart wall switch 154 and/or smart plug 153).

A smart home appliance 156 may be defined as a network-connected home appliance device (e.g. a home appliance device or unit) that may be controlled remotely, e.g. by the smart-home controller 151. The smart home appliance 156 may be any of a wide range of home appliances that are network-connected, including but not limited to smart kitchen appliances, smart stoves and/or ovens, smart refrigerators, smart freezers, smart microwave ovens, smart washing machines, smart drying machines, smart HVAC systems, smart thermostats, smart heaters, smart electrically heated radiators, smart intercom systems, smart garage-door openers, smart floor fans, smart ceiling fans, smart irrigation systems, smart pool heaters, or the like. It will be appreciated that the parameters or functions that may be remotely controlled by the smart-home controller will vary depending on the type of home appliance, but would normally include at least a turning on or off of the smart home appliance 156.

In a similar way, a smart home entertainment device 157 may be defined as a network-connected home entertainment device that may be controlled remotely, e.g. by the smart-home controller 151. Such entertainment devices may include, for instance, visual entertainment devices and/or audio-based entertainment devices. Examples of smart home entertainment devices 157 include smart speakers, smart stereos, smart televisions, or the like.

A smart security monitoring sensor 158 may be defined as a network-connected security monitoring sensors that may be controlled remotely, e.g. by the smart-home controller 151. Examples of smart security monitoring sensors 158 include smart security monitoring cameras, smart video doorbells, or any of the previously described sensors which have been provided with smart connection means.

Each of the smart devices 152 may be able to perform some form of function in response to a command received from the smart-home controller 151. For example, possible commands may be instructions to turn on, turn off, dim, lock, unlock, play, pause, stop, turn the volume up, turn the volume down, mute, hush, turn the temperature up, turn the temperature down, etc.

The smart devices 152 need not be physically located within the premises 120 but may be located in the garden, an outbuilding, or the like instead. For example, a smart device 152 controlling a pool heater or irrigation monitor can be located outside of the premises 120.

It is noted that the smart-home system 150 may be used, through smart plugs 153 and/or smart wall switches 154, to control a variety of non-communicating legacy appliances and devices, such as old conventional washer/dryers, refrigerators, lights, and the like, although such control may be limited to a mere turning on and off of the appliances.

The smart devices 152 may have been acquired from various sources. For example, a first entity (e.g., manufacturer) may produce some of the smart devices 152, while a second entity may produce the remaining smart device(s) 152.

The required data communications between smart devices 152 and the smart-home controller 151 can be carried out using any of a variety of custom or standard wireless protocols (such as IEEE 802.11 based protocols ("Wi-Fi"), Bluetooth or Bluetooth Low Energy ("BLE"), 3G/4G wireless, IEEE 802.15.4 based protocols such as ZigBee or 6LoWPAN, Z-Wave, or the like) and/or any of a variety of custom or standard wired protocols (CAT6 Ethernet, HomePlug, or the like).

Although described in combination with the security monitoring system 100, it will be understood that the smart-home system 150 according to embodiments may be independently installed in a premises 120 without a security monitoring system 100. Similarly, it will be appreciated that the electrical discharge detector 108 may be provided as part of the smart-home system 150 instead of as part of the security monitoring system 100, in which case the smart-home system 150 (and the methods described later in relation to Figs. 16 to 17) may be conveniently used also in premises 120 without a security monitoring system 100. In such a configuration, the electrical discharge detector 108 may be configured to communicate directly with the smart-home controller 151.

The smart-home system 150 may be connected to or communicate with the radio-based sensing arrangement 130. In particular, one or more smart devices 152 and/or the smart-home controller 151 may form nodes 131 in the radio-based sensing arrangement 130.

Fig. 16 shows another exemplary method of operating the security monitoring system 100 where the one or more actions performed in response to the electrical discharge detection includes turning off one or more smart devices.

In step 1601, an electrical discharge, which could be a precursor to a fire, is detected. The electrical discharge may be detected by the electrical discharge detector 108 or by any other suitable method or device. The detection in step 1601 may be carried out according to the method of Fig. 3. The detection in step 1601 is substantially equivalent to the detection in step 401 of Fig. 4 or step 501 of Fig. 5.

The electrical discharge detector 108 may then transmit a detection signal in response to the detected electrical discharge. The detection signal may be transmitted to the security monitoring system 100, the remote monitoring centre 113 and/or the smart-home system 150 to notify the respective system that an electrical discharge has been detected. For instance, the detection signal may be transmitted to the control unit 110 and/or the smart-home controller 151.

In step 1603, an action signal is transmitted to one or more smart devices 152 instructing the one or more smart devices 152 to be turned off. In particular, the one or more smart devices 152 may be instructed to turn off in response to, or after, the electrical discharge has been detected.

At least one, and optionally all, of the one or more smart devices 152 that are instructed to be turned off is connected to the electrical wiring in the premises 120. Hence, the load on the electrical wiring is reduced, which in turn may reduce the risk of a potential fire arising as a consequence of the detected electrical discharge or any subsequent electrical discharges.

It is noted that in some embodiments, the smart-home system 150 may simply turn off all of its smart devices 152 irrespective of whether they are connected to the electrical wiring in which the electrical discharge has been detected or not, whereas in other embodiments, the system may only turn off those smart devices 152 connected to the electrical wiring (i.e. those that are mains-powered).

In some embodiments, all smart devices 152 connected to the electrical wiring may be turned off, while in other embodiments, only some of the smart devices 152 connected to the electrical wiring may be turned off, for instance if turning off one or more of the remaining smart devices 152 would be inappropriate (e.g. if one of the smart devices 152 is a smart refrigerator or freezer which must be turned on in order to keep the food therein safe, or the like).

The action signal may be transmitted from the control unit 110 and/or the smart-home controller 151. For example, the control unit 110 may receive a detection signal from the electrical discharge detector 108, and thereafter transmit the action signal to the smart device(s) 152. As another example, the control unit 110 may receive the detection signal from the electrical discharge detector 110, after which the control unit 110 communicates with the smart-home controller 151 which in turn transmits the action signal to the smart device(s) 152 to be turned off. In another example, the electrical discharge detector 108 may transmit the detection signal to the smart home controller 151 (e.g. if there is no security monitoring system 100 installed in the premises 120) which transmits the action signal to the smart devices 152. As yet another example, the electrical discharge detector 108 may transmit the action signal directly to the smart devices 152 (e.g. if the electrical discharge detector 108 is connected to the same network as the smart devices 152 and able to communicate with the smart devices 152 over said network).

It will accordingly be appreciated that the electrical discharge detector 108 and the smart devices 152 may be communicatively connected and any communications (e.g. signals and/or commands) transmitted between the electrical discharge detector 108 and the smart devices 152 may be transmitted directly, or pass through the control unit 110, the remote monitoring centre 113, and/or the smart-home controller 151.

In some embodiments, the device (e.g. the control unit 100 and/or the smart-home controller 151) that receives the detection signal from the electrical discharge detector 108 may be configured to transmit a request to another device (e.g. a user device 112 such as a smart-phone with a smart-home system application and/or a security monitoring system application, the input means 111, a device of the remote monitoring centre 113) asking a user or operator to indicate if any smart devices 152 are to be turned off. The request may, for example, include a list of smart devices 152 that could potentially be turned off, where the user or operator can select those smart devices 152 that they wish to be turned off, or the request may simply be a request to approve or deny whether to turn off smart devices 152. Upon receiving a response from the device, the security monitoring system and/or the smart-home system 150 may instruct smart devices 152 to be turned off in accordance with the response from the device. In some embodiments, the security monitoring system 100 and/or the smart-home system 150 may be configured to turn off the smart devices 152 if no response is received from the device within a predetermined time period.

In step 1605, the one or more smart devices 152 are turned off in response to the transmitted action signal.

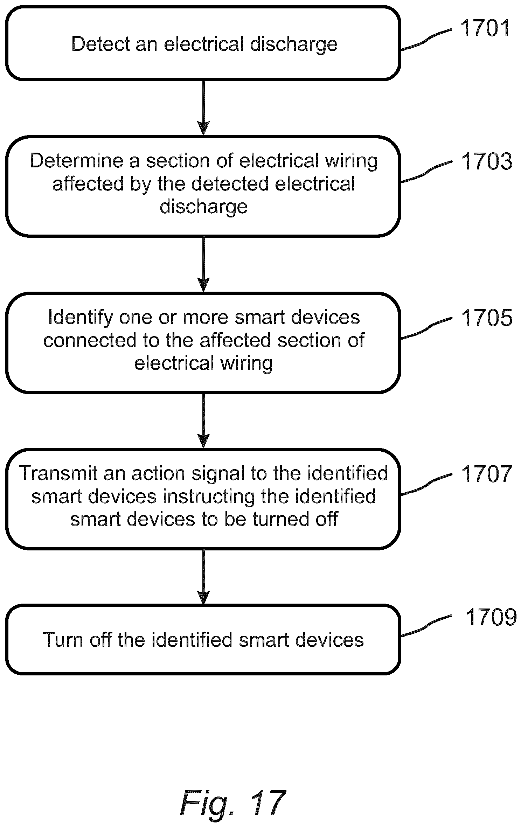

Fig. 17 shows another exemplary method of operating the security monitoring system 100 where the system is further configured to identify an affected section of electrical wiring.

In step 1701, an electrical discharge, which could be a precursor to a fire, is detected. The electrical discharge may be detected by the electrical discharge detector 108 or by any other suitable method or device. This step substantially corresponds to step 1601 of Fig. 16.

The electrical discharge detector 108 may then transmit a detection signal in response to the detected electrical discharge. The detection signal may be transmitted to the security monitoring system 100, the remote monitoring centre 113, and/or the smart-home system 150 to notify the respective system that an electrical discharge has been detected. For instance, the detection signal may be transmitted to the control unit 110 and/or the smart-home controller 151.

In step 1703, the system determines an affected section of electrical wiring. The affected section is a section of electrical wiring in which the electrical discharge has likely occurred.

Step 1703 may comprise determining to which electrical wiring the electrical discharge detector 108 (which detected the electrical discharge) is connected. For example, the premises 120 may comprise two or more separate electrical wirings of which only one was affected by the detected electrical discharge. Here it is noted that the system may comprise more than one electrical discharge detector 108, for example one electrical discharge detector 108 per electrical wiring, and the system may therefore easily determine which electrical wiring was affected by the detected electrical discharge by knowing to which electrical wiring the electrical discharge detector(s) 108 are connected.

Step 1703 may alternatively, or additionally, comprise determining a section of an electrical wiring in which the detected electrical discharge likely occurred. To accomplish this, the system may comprise a plurality of electrical discharge detectors 108 connected to the same electrical wiring, e.g. a first electrical discharge detector 108 connected to a first electrical outlet 203 of the electrical wiring and a second electrical discharge detector 108 connected to a second electrical outlet 203 of the same electrical wiring.

The determination may be made using similar techniques as described in relation to step 803 of Fig. 8. In particular, the section of the electrical wiring in which the electrical discharge is likely to have occurred may be determined using the time-of-arrival techniques for the transient signals identified by the plurality of electrical discharge detectors 108 as described in step 803 of Fig. 8. The system may thereafter determine an affected section of the electrical wiring in dependence on where the two electrical discharge detectors 108 are located and the layout of the electrical wiring in the premises.

In step 1705, which is generally performed after the affected section of electrical wiring has been determined, one or more smart devices 152 are identified that are connected to the affected section of electrical wiring.

Here it is noted that the smart-home system 150 (and in turn the smart devices 152) may cover an area which does not exactly correspond to an area covered by a single electrical wiring. Thus, different smart devices 152 of the smart-home system 150 may be connected to different electrical wirings. For example, the smart-home system 150 (and in particular the network on which it operates) may cover the entire premises 120 while there may be two separate electrical wirings covering that same area. As another example, a main building of the premises 120 may have a first electrical wiring and an outbuilding (or the like) may have a second electrical wiring, while the smart-home system 150 extends to cover both the main building and the outbuilding.

In order to identify the smart devices 152 connected to the affected section of electrical wiring, the smart-home system 150 and/or security monitoring system 100 may know the (approximate) location of smart devices 152 within the premises 120.

For example, when a smart device 152 is first plugged in and installed as part of the smart-home system 150, the smart-home system 150 may ask the user to indicate where the smart device 152 is located, e.g. if it is located in the "living room", "kitchen" and so forth. The smart-home system 150 may accordingly store this location information which may be used to identify the relevant smart devices 152.

Once the one or more smart devices 152 have been identified, an action signal is sent, in step 1707, to the identified smart device(s) 152 instructing the one or more identified smart devices 152 to be turned off. This step thus substantially corresponds to step 1603 of Fig. 16.

In step 1709, the identified one or more smart devices 152 are turned off in response to the transmitted command.

Although described in relation to a security monitoring system 100, it will be appreciated that the methods of Figs. 16 and 17 may alternatively be performed by a smart-home system 150 installed separately from the security monitoring system 100. In such a configuration, the required communications and signals may be transmitted between the electrical discharge detector 108, the smart-home controller 151, and the smart devices 152.

It will be understood that the methods described herein may be combined and/or performed individually. In particular, any of the methods of Figs. 4 and 5 may be combined with any combination of one or more methods as described in relation to Figs. 6 to 12 and 16 to 17.

For example, the security monitoring system 100 may both alter the state of one or more sensors 101 in accordance with any of the methods of Figs. 6 to 8 and turn off one or more smart devices 152 in accordance with any of the methods of Figs. 16 and 17. Similarly, the security monitoring system 100 may determine if anyone is present in the premises 120 according to the any of the methods in Figs. 10 to 12 and/or using the radio-based sensing arrangement 130, after which one or more actions is selected and performed (which may or may not be an action according to any of the methods of, for example, Figs. 6 to 8 or 16 to 17).

The various embodiments described above are provided by way of illustration only and should not be construed to limit the invention. For example, the principles herein may be applied to any security monitoring system or alarm system. Those skilled in the art will readily recognize various modifications and changes that may be made to the present invention without following the example embodiments and applications illustrated and described herein, and without departing from the scope of the present disclosure.

Throughout this specification, the word "may" is used in a permissive sense (i.e. meaning having the potential to), rather than in the mandatory sense (i.e. meaning must).

Throughout this specification, the words "comprise", "include", and variations of the words, such as "comprising" and "comprises", "including", "includes", do not exclude other elements or steps.

As used throughout this specification, the singular forms "a", "an", and "the", include plural referents unless explicitly indicated otherwise. Thus, for example, reference to "an" element also includes a combination of two or more elements, notwithstanding use of other terms and phrases for one or more elements, such as "one or more" or "at least one".

The term "or" is, unless indicated otherwise, non-exclusive, i.e. encompassing both "and" and "or". For example, the feature "A or B" includes feature "A", feature "B" and feature "A and B".

Unless otherwise indicated, statements that one value or action is "based on", "in response to" and/or "in dependence on" another condition or value or action, encompass both instances in which the condition or value or action is the sole factor and instances where the condition or value or action is one factor among a plurality of factors.

Unless otherwise indicated, statements that "each" instance of some collection have some property should not be read to exclude cases where some otherwise identical or similar members of a larger collection do not have the property, i.e. each does not necessarily mean each and every.

## Claims

1. A security monitoring system for monitoring of a premises, the security monitoring system comprising:
a control unit, and
an electrical discharge detector configured to detect electrical discharges in electrical wiring of the premises.

2. The security monitoring system according to claim 1, wherein the electrical discharge detector comprises:
a plug for connection to an outlet of the electrical wiring, and
a detection unit for detecting an electrical discharge.

3. The security monitoring system according to claim 1 or 2, wherein the electrical discharge detector is configured to:
measure an electrical signal waveform of the electrical wiring,
identify one or more transient signals within the waveform; and
detect the electrical discharge in dependence on transient characteristics of the one or more transient signals.

4. The security monitoring system according to any preceding claim, wherein the security monitoring system is configured to, in response to a detected electrical discharge, transmit an action signal to one or more devices instructing the one or more devices to perform one or more actions.

5. The security monitoring system according to any preceding claim, wherein the control unit is configured to receive a detection signal from the electrical discharge detector in response to a detected electrical discharge, and to transmit, in response to the detection signal, an action signal to one or more devices instructing the one or more devices to perform one or more actions.

6. The security monitoring system according to any preceding claim, wherein the security monitoring system further comprises a remote monitoring centre.

7. The security monitoring system according to any preceding claim, wherein the control unit is configured to transmit an alert signal to the remote monitoring centre in response to a detected electrical discharge.

8. The security monitoring system according to any preceding claim, wherein the security monitoring system further comprises one or more sensors for monitoring a parameter related to the premises.

9. The security monitoring system according to claim 8, wherein the one or more sensors comprises a presence sensor, a radiation-based sensor, an infrared sensor, a passive infrared sensor, a line-of-sight sensor, a motion sensor, a photosensor, a temperature sensor, a shock sensor, a sound sensor, and/or an image capturing sensor.

10. The security monitoring system according to any preceding claim, wherein the security monitoring system further comprises a radio-based sensing arrangement.

11. The security monitoring system according to any preceding claim, wherein the security monitoring system is connected to a smart-home system.

12. A method of operating a security monitoring system of a premises, the method comprising:
detecting, by an electrical discharge detector of the security monitoring system, an electrical discharge in electrical wiring of the premises; and
in response to the detection, transmitting an action signal to a control unit of the security monitoring system.

13. The method according to claim 12, wherein the electrical discharge detector is connected to the electrical wiring, and wherein the step of detecting comprises:
measuring an electrical signal waveform of the electrical wiring,
identifying one or more transient signals within the waveform; and
detecting the electrical discharge in dependence on transient characteristics of the one or more transient signals.
